(19) Europäisches Patentamt
European Patent Office
Office européen des brevets

(11) EP 4 428 842 A1

(12) EUROPEAN PATENT APPLICATION
published in accordance with Art. 153(4) EPC

(43) Date of publication:
11.09.2024 Bulletin 2024/37

(51) International Patent Classification (IPC):
G09F 9/00 (2006.01)    B60K 35/00 (2024.01)

(21) Application number: 22889949.8

(52) Cooperative Patent Classification (CPC):
B60K 35/00; G09F 9/00

(22) Date of filing: 31.10.2022

(86) International application number:
PCT/JP2022/040846

(87) International publication number:
WO 2023/080129 (11.05.2023 Gazette 2023/19)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 04.11.2021 JP 2021180542

(71) Applicant: AGC INC.
Chiyoda-ku,
Tokyo 1008405 (JP)

(72) Inventors:
• HOKARI Ryou
Tokyo 100-8405 (JP)
• INOUE Atsushi
Tokyo 100-8405 (JP)
• WATANABE Toshinari
Tokyo 100-8405 (JP)

(74) Representative: Müller-Boré & Partner
Patentanwälte PartG mbB
Friedenheimer Brücke 21
80639 München (DE)

(54) DISPLAY DEVICE

(57) The present invention relates to an on-vehicle display device in which a cover member (2), a display panel (3), and a bottom member (5) that is to be fixed to a vehicle are laminated in this order. The bottom member (5) has a plate part, a rib, and at least two fixing points. The ratio YH/YH$_{cg}$ of YH to YH$_{cg}$, which indicate specific distances, is not more than 0.5. When a specific imaginary line that passes through a specific reference point and the bottom member (5) is defined as D and n is defined as an integer of two or greater, disposed on the imaginary line are members up to an n-th layer, where the cover member (2) is a first layer and the bottom member (5) is excluded, and a specific expression (1) is satisfied.

[FIG. 6]

**Description**

TECHNICAL FIELD

The present invention relates to a display device.

BACKGROUND ART

An in-vehicle display device that displays information and the like necessary for driving includes a display device including a display panel and a cover member that covers the display panel. In such a display device, it is required to reduce damage to the cover member even when subjected to an impact. For example, Patent Literature 1 discloses an in-vehicle display device capable of improving the end portion impact of the cover member.

CITATION LIST

PATENT LITERATURE

Patent Literature 1: WO2016/027812

SUMMARY OF INVENTION

TECHNICAL PROBLEM

In the in-vehicle display device, the way the impact is transmitted to the cover member changes depending on a position where the in-vehicle display device is fixed to a vehicle. Therefore, for example, it is also required to reduce damage to the cover member even in a state where the vicinity of an upper end of the display device is fixed to a vehicle.
The present invention has been made in view of the above problem, and an object of the present invention is to provide a display device capable of reducing damage to a cover member even in a state where the vicinity of an upper end of the display device is also fixed to a vehicle.

SOLUTION TO PROBLEM

The display device according to the present embodiment for solving the above problem and achieving the object is as follows.
An in-vehicle display device, including: a cover member, a display panel, and a bottom member configured to be fixed to a vehicle, the cover member, the display panel, and the bottom member being stacked in this order, in which in a thickness direction of the cover member, when a direction from the cover member toward the bottom member is defined as a first direction, the cover member includes a first main surface opposite to the first direction, a second main surface in the first direction, an end surface connecting the first main surface and the second main surface, and a corner formed by the first main surface and the end surface, the bottom member includes a plate portion and ribs protruding from a main surface of the plate portion in the first direction, and at least two fixing points configured to be fixed to the vehicle are formed on a main surface of the bottom member in the first direction, when a virtual plane passing through an intermediate point between two of the fixing points and perpendicular to a line connecting the two fixing points is defined as a virtual plane R, a length of an intersection line between a main surface of the cover member and the virtual plane R is defined as a distance $YH_{cg}$, and a length from an upper end of an intersection line between a main surface of the display panel and the virtual plane R to a point corresponding to the intermediate point is defined as a distance YH, a ratio $YH/YH_{cg}$ of the distance YH to the distance $YH_{cg}$ is 0.5 or less, when a position on the corner of the cover member where distances from the two fixing points are equal is defined as an equidistance point, a position on the corner within a predetermined distance range from the equidistance point is defined as a reference point, a virtual line that passes through the reference point and the bottom member and is inclined at an angle of 30° or more and 45° or less with respect to the first direction is defined as a virtual line D, and n is an integer of 2 or more, members up to an n-th layer are disposed on the virtual line D with the cover member as a first layer, except for the bottom member, and the following Formula (1) is satisfied.
In Formula (1), t is a thickness (mm) of the cover member in the first direction, and Q is a value obtained by the following Formula (2).
In Formula (2), $E_D$ is a Young's modulus (GPa) of the bottom member, $E_{cg}$ is a Young's modulus (GPa) of the cover member, $E_n$ is a Young's modulus (GPa) of the member of the n-th layer, $t_n$ is a thickness (mm) of the member of the n-th layer in the first direction at a region passing through the virtual line D, and to is a value obtained by the following Formula (3).

In Formula (3), a is a thickness (mm) of the plate portion of the bottom member in the first direction, $w_2$ is a width (mm) of a first rib closest to a point on the plate portion through which the virtual line D passes among the ribs of the bottom member, $w_1$ is a distance (mm) between the first rib and a second rib that is positioned in an extending direction of a line perpendicular to a center line of the first rib and passing through the point on the plate portion through which the virtual line D passes, h is a thickness (mm) of the rib in the first direction, and b is represented by the following Formula (4).

In Formula (4), a, $w_1$, $w_2$, and h are the same as those in Formula (3).

[Math. 1]

$$Q \leqq 109.17t^2 - 165.5t + 94.058 \qquad \text{... Formula (1)}$$

$$Q = E_D \cdot t_D{}^2 / (Ecg \cdot t^2 + \cdots + E_n \cdot t_n{}^2)/100 \qquad \text{... Formula (2)}$$

$$t_D = \sqrt[3]{a^3 + \frac{w_2}{w_1}h^3 + 12a\left(b - \frac{a}{2}\right)^2 12\frac{w_2}{w_1}h\left(\frac{h}{2} + a - b\right)^2} \qquad \text{... Formula (3)}$$

$$b = \frac{0.5w_1 \cdot a^2 + 0.5w_2 \cdot h^2 + w_2 \cdot a \cdot h}{w_1 \cdot a + w_2 \cdot h} \qquad \text{... Formula (4)}$$

In order to solve the above problem and achieve the object, a display device according to another embodiment is as follows.

An in-vehicle display device, including: a cover member, a display panel, and a bottom member configured to be fixed to a vehicle, the cover member, the display panel, and the bottom member being stacked in this order, in which in a thickness direction of the cover member, when a direction from the cover member toward the bottom member is defined as a first direction, the cover member includes a first main surface opposite to the first direction, a second main surface in the first direction, an end surface connecting the first main surface and the second main surface, and a corner formed by the first main surface and the end surface, the bottom member includes a plate portion and ribs protruding from a main surface of the plate portion in the first direction, and one fixing point configured to be fixed to the vehicle is formed on a main surface of the bottom member in the first direction, when a virtual plane passing through the fixing point and including the thickness direction and a vertical direction of the cover member at the fixing point is defined as a virtual plane R, a length of an intersection line between a main surface of the cover member and the virtual plane R is defined as a distance $YH_{cg}$, and a length from an upper end of an intersection line between a main surface of the display panel and the virtual plane R to a point corresponding to the fixing point is defined as a distance YH, a ratio $YH/YH_{cg}$ of the distance YH to the distance $YH_{cg}$ is 0.5 or less, when a position on the corner of the cover member where a distance from the fixing point is the shortest is defined as an equidistance point, a position on the corner within a predetermined distance range from the equidistance point is defined as a reference point, a virtual line that passes through the reference point and the bottom member and is inclined at an angle of 30° or more and 45° or less with respect to the first direction is defined as a virtual line D, and n is an integer of 2 or more, members up to an n-th layer are disposed on the virtual line D when the cover member is a first layer and the bottom member is excluded, and the following Formula (1) is satisfied.

In Formula (1), t is a thickness (mm) of the cover member in the first direction, and Q is a value obtained by the following Formula (2).

In Formula (2), $E_D$ is a Young's modulus (GPa) of the bottom member, $E_{cg}$ is a Young's modulus (GPa) of the cover member, $E_n$ is a Young's modulus (GPa) of the member of the n-th layer, $t_n$ is a thickness (mm) of the member of the n-th layer in the first direction at a region passing through the virtual line D, and to is a value obtained by the following Formula (3).

In Formula (3), a is a thickness (mm) of the plate portion of the bottom member in the first direction, $w_2$ is a width (mm) of a first rib closest to a point on the plate portion through which the virtual line D passes among the ribs of the bottom member, $w_1$ is a distance (mm) between the first rib and a second rib that is positioned in an extending direction of a line perpendicular to a center line of the first rib and passing through the point on the plate portion through which the virtual line D passes, h is a thickness (mm) of the first rib and the second rib in the first direction, and b is represented by the following Formula (4).

In Formula (4), a, $w_1$, $w_2$, and h are the same as those in Formula (3).

[Math. 2]

$$Q \leqq 109.17t^2 - 165.5t + 94.058 \qquad \text{... Formula (1)}$$

$$Q = E_D \cdot t_D{}^2 / (Ecg \cdot t^2 + \cdots + E_n \cdot t_n{}^2)/100 \qquad \text{... Formula (2)}$$

$$t_D = \sqrt[3]{a^3 + \frac{w_2}{w_1}h^3 + 12a\left(b - \frac{a}{2}\right)^2 12\frac{w_2}{w_1}h\left(\frac{h}{2} + a - b\right)^2} \qquad \text{... Formula (3)}$$

$$b = \frac{0.5w_1 \cdot a^2 + 0.5w_2 \cdot h^2 + w_2 \cdot a \cdot h}{w_1 \cdot a + w_2 \cdot h} \qquad \text{... Formula (4)}$$

ADVANTAGEOUS EFFECTS OF INVENTION

According to the present invention, damage to the cover member can be reduced even in a state where the vicinity of the upper end of the display device is fixed to a vehicle.

BRIEF DESCRIPTION OF DRAWINGS

[FIG. 1] FIG. 1 is a schematic diagram illustrating a display device according to the present embodiment.
[FIG. 2] FIG. 2 is a cross-sectional view taken along line A-A in FIG. 1.
[FIG. 3] FIG. 3 is a schematic diagram of a bottom member.
[FIG. 4] FIG. 4 is a schematic diagram of the display device viewed from a display surface.
[FIG. 5] FIG. 5 is a cross-sectional view taken along line B-B in FIG. 1.
[FIG. 6] FIG. 6 is a cross-sectional view taken along line C-C in FIG. 4.
[FIG. 7A] FIG. 7A is a partially enlarged schematic diagram of another example of a cover member.
[FIG. 7B] FIG. 7B is a partially enlarged schematic diagram of another example of a cover member.
[FIG. 8] FIG. 8 is a schematic diagram illustrating another example of a cross section of the display device.
[FIG. 9] FIG. 9 is a partially enlarged schematic diagram of the bottom member.
[FIG. 10] FIG. 10 is a schematic cross-sectional view of a display device of another example of the present embodiment.
[FIG. 11] FIG. 11 is a schematic diagram of a display device according to another example of the present embodiment.
[FIG. 12] FIG. 12 is a cross-sectional view taken along line D-D in FIG. 11.
[FIG. 13] FIG. 13 is a schematic diagram of a display device according to another example of the present embodiment.
[FIG. 14] FIG. 14 is a schematic diagram illustrating positions of ribs of the bottom member in the present embodiment.
[FIG. 15] FIG. 15 is a schematic diagram illustrating positions of ribs of a bottom member in another example of the present embodiment.
[FIG. 16] FIG. 16 is a schematic diagram illustrating positions of ribs of a bottom member in another example of the present embodiment.
[FIG. 17] FIG. 17 is a schematic diagram illustrating positions of ribs of a bottom member in another example of the present embodiment.
[FIG. 18] FIG. 18 is a schematic diagram illustrating a rib having a trapezoidal cross-sectional shape.
[FIG. 19] FIG. 19 is a schematic diagram of a display device according to another example of the present embodiment.
[FIG. 20] FIG. 20 is a schematic front view of a display device according to Examples.
[FIG. 21] FIG. 21 is a graph showing the value of Q and an evaluation result in each Example.

DESCRIPTION OF EMBODIMENTS

A preferred embodiment of the present invention will be described below in detail with reference to the accompanying drawings. The present invention is not limited to the present embodiment and also includes a combination of embodiments in the case where there are a plurality of embodiments. In addition, numerical values include rounding ranges.

(1. Configuration of Display Device)

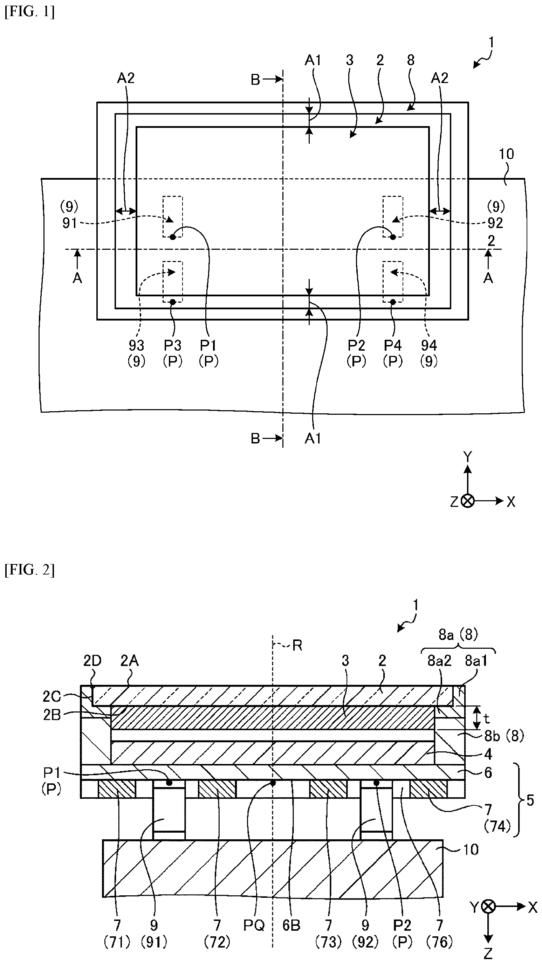

FIG. 1 is a schematic diagram illustrating a display device according to the present embodiment. As illustrated in FIG. 1, a display device 1 according to the present embodiment is an in-vehicle display device provided in a vehicle. The display device 1 is, for example, a car navigation device. The display device 1 can be used for any purpose and may be another display device such as a display audio device mounted on a vehicle. As will be described in detail later, the display device 1 is fixed to an interior portion 10 of a vehicle via fixing points P formed on a back surface opposite to a display surface. The interior portion 10 is a member provided inside the vehicle, and is, for example, a part of a dashboard of the vehicle.

Hereinafter, a direction from the display surface to the back surface in a thickness direction of the display device 1 is referred to as a first direction. In FIGS. 1 to 17 and 20, the first direction is defined as a Z direction, a direction (right direction in the example of FIG. 1) orthogonal to the Z direction and oriented in one direction along a horizontal plane when the display device 1 is attached to the vehicle is defined as an X direction, and among directions orthogonal to the Z direction and the X direction, a direction oriented upward in a vertical direction is defined as a Y direction. In the present embodiment, an end portion of the display device 1 in the Y direction is an upper end portion (upper end portion) in the vertical direction.

As for the first direction, the Z direction, the X direction, and the Y direction, the "direction" is used as a concept having an orientation. That is, the term "Z direction" refers to the orientation determined above, and the term "direction opposite to the Z direction" refers to an orientation opposite to the orientation determined above.

FIG. 2 is a cross-sectional view taken along line A-A in FIG. 1. As illustrated in FIG. 2, the display device 1 includes a cover member 2, a display panel 3, a backlight unit 4, a bottom member 5, and a sidewall member 8. In the display device 1, the cover member 2, the display panel 3, the backlight unit 4, and the bottom member 5 are disposed (overlapped) in this order in the Z direction, and the sidewall member 8 having a frame shape is disposed around the cover member 2, the display panel 3, and the backlight unit 4. That is, the bottom member 5 and the sidewall member 8 constitute a housing that houses the cover member 2 and the display panel 3, the bottom member 5 covers back surfaces (surfaces opposite to surfaces on a display side) of the cover member 2 and the display panel 3, and the sidewall member 8 covers side surfaces of the cover member 2 and the display panel 3.

(Cover Member)

The cover member 2 is a transparent plate-shaped member that transmits visible light. The cover member 2 has a first main surface 2A which is a main surface on a side (display surface side) opposite in the Z direction, a second main surface 2B which is a main surface in the Z direction, and an end surface 2C which connects the first main surface 2A and the second main surface 2B. The end surface 2C is also referred to as a side surface of the cover member 2. Hereinafter, an edge portion of the cover member 2 formed by the first main surface 2A and the end surface 2C is referred to as a corner 2D. The corner 2D is also referred to as a boundary portion between the first main surface 2A and the end surface 2C.

The thickness t of the cover member 2 is preferably 0.5 mm to 2.5 mm, more preferably 0.7 mm to 2.0 mm, and still more preferably 1.1 mm to 1.3 mm. The thickness t is preferably 0.5 mm or more, more preferably 0.7 mm or more, and still more preferably 1.1 mm or more. The thickness t of the cover member 2 is preferably 2.5 mm or less, more preferably 2.0 mm or less, and still more preferably 1.3 mm or less. The thickness t is a length from the first main surface 2A to the second main surface 2B in the Z direction.

In the example of the present embodiment, the cover member 2 has a flat plate shape that is rectangular when viewed from the Z direction. As for a size of the cover member 2, for example, in the case where the cover member 2 is rectangular, a length in a longer direction (X direction in the example of the present embodiment) may be 100 mm or more and 800 mm or less, and a length in a shorter direction (Y direction in the example of the present embodiment) may be 40 mm or more and 300 mm or less. The cover member 2 is not limited to a flat plate shape that is rectangular when viewed from the Z direction, and may have any shape. The cover member 2 may have, for example, an elliptical shape when viewed from the Z direction, or may have, for example, a curved shape. In addition, the cover member 2 may have any size.

The Young's modulus ($E_{cg}$) of the cover member 2 is preferably 60 GPa to 90 GPa, more preferably 70 GPa to 80 GPa, and still more preferably 70 GPa to 75 GPa. The Young's modulus ($E_{cg}$) is preferably 60 GPa or more, and more preferably 70 GPa or more. The Young's modulus ($E_{cg}$) of the cover member 2 is preferably 90 GPa or less, more preferably 80 GPa or less, and still more preferably 75 GPa or less. The Young's modulus of the members including the cover member 2 may be obtained by a tensile test (JIS K7161-1, 2: 2014, JIS K7113: 1995).

The cover member 2 is made of glass. In the case where the cover member 2 is made of glass, the cover member 2 is preferably made of a strengthened glass such as a chemically strengthened glass.

In the case where the cover member 2 is made of a strengthened glass, the thickness (DOL) of a compressive stress layer of the cover member 2 is, for example, preferably 10 $\mu$m to 180 $\mu$m, more preferably 15 $\mu$m to 180 $\mu$m, still more preferably 25 $\mu$m to 50 $\mu$m, and even more preferably 30 $\mu$m to 50 $\mu$m. The thickness (DOL) of the compressive stress layer is preferably 10 $\mu$m or more, more preferably 15 $\mu$m or more, still more preferably 25 $\mu$m or more, and even more preferably 30 $\mu$m or more. The thickness (DOL) of the compressive stress layer is, for example, preferably 180 $\mu$m or less, and more preferably 50 $\mu$m or less.

The surface compressive stress (CS) in the compressive stress layer is preferably 500 MPa or more, more preferably 650 MPa or more, and still more preferably 750 MPa or more. Although an upper limit is not particularly limited, for example, CS is preferably 1200 MPa or less.

Examples of a method for subjecting glass to a chemical strengthening treatment to obtain a chemically strengthened glass include, typically, a method of immersing glass in a $KNO_3$ molten salt to conduct an ion exchange treatment, followed by cooling the glass to around room temperature. Treatment conditions such as a temperature of the $KNO_3$ molten salt and an immersion time may be set such that the surface compressive stress and the thickness of the compressive stress layer have desired values.

Examples of a glass type include a soda lime glass and an aluminosilicate glass ($SiO_2$-$Al_2O_3$-NazO-based glass). Among them, an aluminosilicate glass is preferred from the viewpoint of strength.

Examples of a glass material include a glass material containing, in terms of mol% based on oxides, 50% or more and 80% or less of SiOz, 1% or more and 20% or less of $Al_2O_3$, 6% or more and 20% or less of $Na_2O$, 0% or more and 11% or less of $K_2O$, 0% or more and 15% or less of MgO, 0% or more and 6% or less of CaO, and 0% or more and 5% or less of $ZrO_2$.

A glass for chemical strengthening, which is based on an aluminosilicate glass, (for example, "Dragontrail (registered trademark)" manufactured by AGC Inc.) is also suitably used.

The cover member 2 is not limited to glass, and may be, for example, a transparent resin member.

(Display Panel)

The display panel 3 is a panel that displays an image, and is disposed in the Z direction of the cover member 2 to overlap the cover member 2. A display surface of the display panel 3, which is a surface opposite in the Z direction, is adhered to the second main surface 2B of the cover member 2 with an adhesive layer (not illustrated). The adhesive layer is, for example, an optical clear adhesive (OCA) film or an OCA tape, and a thickness (length in the Z direction) thereof is, for example, 5 $\mu$m or more and 400 $\mu$m or less, and preferably 50 $\mu$m or more and 200 $\mu$m or less. The thickness (length in the Z direction) of the adhesive layer is preferably 5 $\mu$m or more, and more preferably 50 $\mu$m or more. The thickness is also preferably 400 $\mu$m or less, and more preferably 200 $\mu$m or less.

The display panel 3 is a liquid crystal panel, an organic electro-luminescence (EL) panel, a flexible organic EL panel, a plasma display panel (PDP), an electronic ink panel, or the like, and may include a touch panel or the like. In the case where the display panel 3 includes a glass substrate, the glass substrate is the thickest and controls rigidity of the entire display panel. Therefore, the Young's modulus of the glass substrate may be regarded as the Young's modulus of the display panel 3.

The Young's modulus of the display panel 3 is preferably 2 GPa to 90 GPa, more preferably 60 GPa to 90 GPa, and still more preferably 70 GPa to 75 GPa. The Young's modulus is preferably 2 GPa or more, more preferably 60 GPa or more, and still more preferably 70 GPa or more. The Young's modulus of the display panel 3 is preferably 90 GPa or less, and more preferably 75 GPa or less.

The thickness of the display panel 3 is preferably 0.05 mm to 2.0 mm, more preferably 1.0 mm to 2.0 mm, and still more preferably 1.1 mm to 1.3 mm. The thickness is preferably 0.05 mm or more, more preferably 1.0 mm or more, and still more preferably 1.1 mm or more. The thickness of the display panel is preferably 2.0 mm or less, and more preferably 1.3 mm or less. The thickness of the display panel 3 is a length in the Z direction from a main surface of the display panel 3 opposite in the Z direction to a main surface in the Z direction.

As illustrated in FIG. 1, when viewed from the Z direction, a distance from an end portion of the cover member 2 in the Y direction to an end portion of the display panel 3 in the Y direction is defined as a distance A1. From the viewpoint of adhering and holding the cover member 2 with sufficient adhesive strength, the distance A1 is preferably 2 mm or more and 30 mm or less, and more preferably 5 mm or more and 20 mm or less. The distance A1 is preferably 2 mm or more, and more preferably 5 mm or more. The distance A1 is also preferably 30 mm or less, and more preferably 20 mm or less. The numerical range of the distance A1 can also be applied to a distance from an end portion of the cover member 2 opposite to the Y direction to an end portion of the display panel 3 opposite to the Y direction.

As illustrated in FIG. 1, when viewed from the Z direction, a distance from an end portion of the cover member 2 in the X direction to an end portion of the display panel 3 in the X direction is defined as a distance A2. From the viewpoint of adhesive strength and design, the distance A2 is preferably 2 mm or more and 200 mm or less, and more preferably 5 mm or more and 150 mm or less. The distance A2 is preferably 2 mm or more, and more preferably 5 mm or more. The distance A2 is also preferably 200 mm or less, and more preferably 150 mm or less. The numerical range of the distance A2 can also be applied to a distance from an end portion of the cover member 2 opposite to the X direction to an end portion of the display panel 3 opposite to the X direction.

(Backlight Unit)

The backlight unit 4 is a light source that irradiates the display panel 3 with light for image display, and is disposed in the Z direction of the display panel 3 to overlap the display panel 3.

The backlight unit 4 is generally composed of members such as a lens sheet, a diffusion sheet, a light guide plate, a lamp, and a reflector. Among these members, the light guide plate is usually the thickest, and the light guide plate controls rigidity of the entire backlight unit 4. Therefore, the Young's modulus of the light guide plate may be regarded as the Young's modulus of the backlight unit 4.

The Young's modulus of the backlight unit 4 is preferably 1 GPa to 90 GPa, more preferably 2 GPa to 85 GPa, and still more preferably 60 GPa to 85 GPa. The Young's modulus is preferably 1 GPa or more, more preferably 2 GPa or more, and still more preferably 60 GPa or more. The Young's modulus of the backlight unit 4 is preferably 90 GPa or less, and more preferably 85 GPa or less.

The thickness of the backlight unit 4 is preferably 1 mm to 10 mm, more preferably 2 mm to 6 mm, and still more preferably 3 mm to 5 mm. The thickness is preferably 1 mm or more, more preferably 2 mm or more, and still more preferably 3 mm or more. The thickness of the backlight unit 4 is preferably 10 mm or less, more preferably 6 mm or less, and still more preferably 5 mm or less. The thickness of the backlight unit 4 is a length in the Z direction from a main surface of the backlight unit 4 opposite in the Z direction to a main surface in the Z direction.

The display device 1 may not be provided with the backlight unit 4. In this case, in the display device 1, the cover member 2, the display panel 3, and the bottom member 5 are disposed (overlapped) in this order in the Z direction. In the case where the backlight unit 4 is not provided, a self-luminous display panel that does not require the backlight unit 4, such as an organic EL panel or a micro LED panel, is selected as the display panel 3.

(Bottom Member)

The bottom member 5 is disposed in the Z direction of the display panel 3 (the backlight unit 4 in the present embodiment) to overlap the display panel 3 (the backlight unit 4 in the present embodiment), and can be said as being a bottom portion of the housing.

The bottom member 5 includes a plate portion 6 and ribs 7. The plate portion 6 is a plate-shaped member disposed to overlap the display panel 3. The ribs 7 are members formed to protrude from a main surface 6B of the plate portion 6 in the Z direction, and have a quadrangular prism shape in the present embodiment. By forming the bottom member 5 into a shape having the ribs 7, the display device 1 can be made lighter in weight as compared with a case where the bottom member 5 is formed into a thick plate shape having no rib 7.

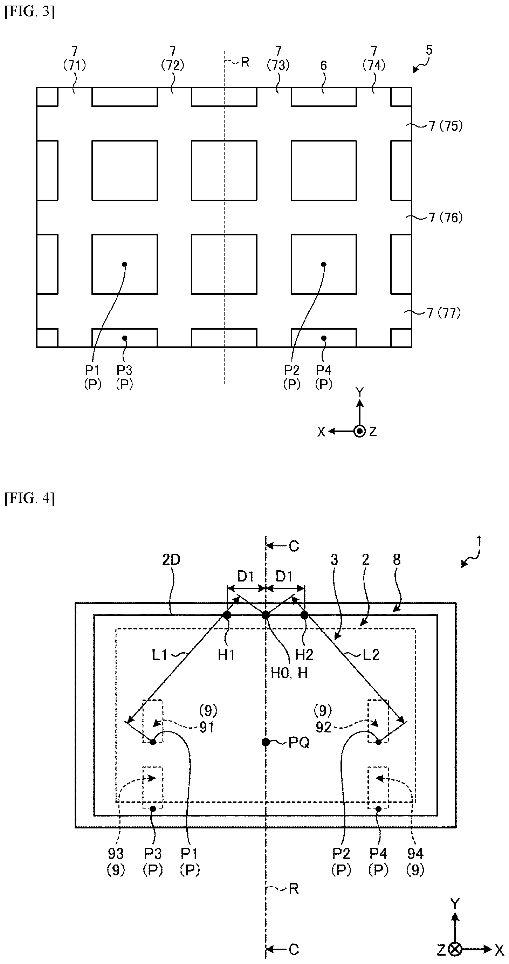

FIG. 3 is a schematic diagram of a bottom member. As illustrated in FIG. 3, when the bottom member 5 of the present embodiment is viewed from the Z direction, a plurality of ribs 7 are provided in a lattice shape in the bottom member 5. Specifically, a plurality of ribs 7 (rib 71, rib 72, rib 73, and rib 74) extending in the Y direction in FIG. 3 intersect a plurality of ribs 7 (rib 75, rib 76, and rib 77) extending in the X direction in FIG. 3. The shape of the ribs 7 is not limited to FIG. 3 and may be any shape, and may be, for example, a curved shape instead of a linear shape, or may not be provided in a grid shape. The bottom member 5 may not have the ribs 7. In this case, the bottom member 5 includes only the plate portion 6.

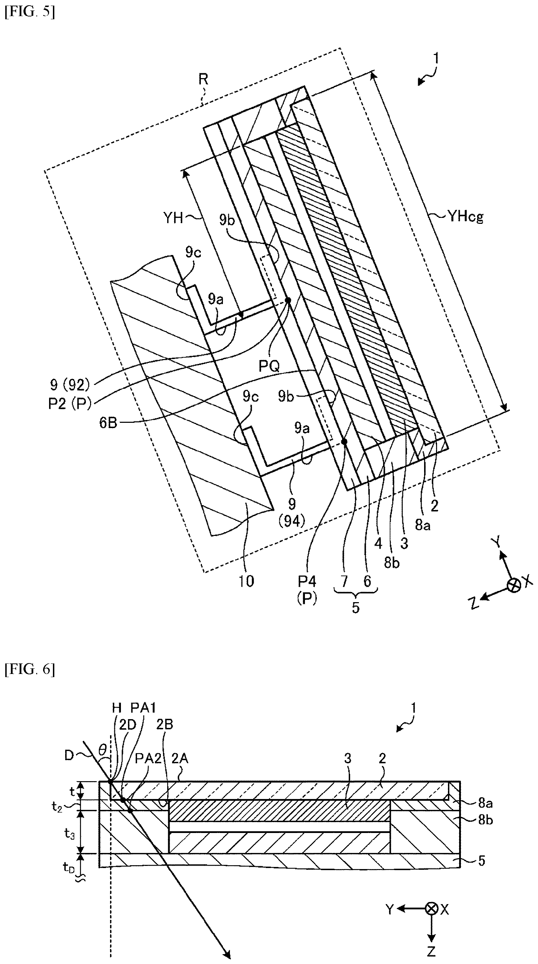

In FIG. 5, a fixing point P is formed on a main surface 5A of the bottom member 5 in the Z direction. The fixing point P is a portion of the bottom member 5 serving as an interface to be fixed to a vehicle (to the interior portion 10 in the present embodiment), and is a portion to which a bracket 9, which will be described later, is attached in the present embodiment.

The bottom member 5 is fixed to the bracket 9 in a state where the main surface 5A is in contact with a fixing member (here, the bracket 9). When a region of the main surface 5A that comes into contact with the fixing member is defined as a contact region, it can be said that the fixing point P is a point on the contact region. The fixing point P may be any position on the contact region, and may be, for example, a midpoint position in the X direction of a side positioned opposite to the Y direction among sides of the contact region. It can be said that one fixing point P is formed for each contact region. That is, in the case where there are a plurality of fixing points P, it can be said that a plurality of contact regions are formed at separate positions and one fixing point P is formed in each contact region. In the case where there is one fixing point P, it can be said that there is one contact region.

For example, in the case where the bottom member 5 is fixed to the bracket 9, a position on the main surface 5A overlapping a midpoint of one side of an end of a convex surface 9a of the bracket 9 (that is, a midpoint in the X direction of a side of the contact region opposite to the Y direction) may be set as the fixing point P. In the case where the bottom member 5 is fixed to the bracket 9 with a fixing tool such as a bolt, the fixing point P may be a portion of the main surface 5A where a hole (for example, a bolt hole), into which the fixing tool is inserted, is open, or in the case where the bottom member 5 is fixed to the bracket 9 with a plurality of fixing tools, the fixing point P may be positioned at a center position between portions where holes (for example, bolt holes), into which the fixing tools are inserted, are open. For example, in the case where the bottom member 5 is fixed to the bracket 9 with an adhesive or the like, the fixing point P may be a point on the contact region of the main surface 5A to which the adhesive is applied. For example, the bottom member 5 may be fixed to a vehicle by forming a protrusion on the main surface 5A of the bottom member 5 and inserting the protrusion into a recess formed in the vehicle (the interior portion 10 in the present embodiment). In this case, the protrusion of the bottom member 5 may be regarded as the bracket 9 without separately providing the bracket 9. In this case, a surface of the protrusion of the bottom member 5 in the Z direction may be the contact region, and a point on the contact region may be the fixing point P. For example, the bottom member 5 may be fixed to a vehicle by forming a recess in the main surface 5A of the bottom member 5 and inserting a protrusion formed on the vehicle (the interior portion 10 in the present embodiment) into the recess of the main surface 5A. In this case, the protrusion of the vehicle may be regarded as the bracket 9 without separately providing the bracket 9. In this case, a surface of the recess of the bottom member 5 in the Z direction may be the contact region, and a point on the contact region may be the fixing point P. The position of the fixing point P and the like will be described later.

In the case where the bottom member 5 has the ribs 7, the Young's modulus is preferably 1.5 GPa or more and 100 GPa or less, and more preferably 40 GPa or more and 80 GPa or less. The Young's modulus of the bottom member 5 in the case of having the ribs 7 is preferably 1.5 GPa or more, and more preferably 40 GPa or more. The Young's modulus is also preferably 100 GPa or less, and more preferably 80 GPa or less.

In the case where the bottom member 5 does not have the rib 7, the Young's modulus is preferably 40 GPa or more and 250 GPa or less, and more preferably 60 GPa or more and 230 GPa or less. The Young's modulus of the bottom member 5 in the case of having no rib 7 is preferably 40 GPa or more, and more preferably 60 GPa or more. The Young's modulus is also preferably 250 GPa or less, and more preferably 230 GPa or less.

As a material of the bottom member 5, for example, a metal (simple substance) or an alloy containing a metal element such as aluminum or magnesium is preferred. The material of the bottom member 5 may be resin or a laminate of a resin layer and a metal layer.

(Sidewall member)

The sidewall member 8 is a frame-shaped member that is provided to surround the cover member 2, the display panel 3, and the backlight unit 4 when viewed from the Z direction, and can be said as being a side wall portion of the housing.

In FIG. 2, in the example of the present embodiment, the sidewall member 8 includes sidewall members 8a and 8b. The sidewall member 8a includes members 8a1 and 8a2. The member 8a1 is a frame-shaped portion surrounding the cover member 2. The member 8a2 is a portion that protrudes inward in a radial direction from an end portion of the member 8a1 in the Z direction when a central axis of the cover member 2 along the Z direction is taken as an axial direction. The central axis of the cover member 2 is an axis that passes through a center point of the cover member 2 when viewed from the Z direction and extends in the Z direction. The member 8a2 supports an outer peripheral region of the second main surface 2B of the cover member 2 in the Z direction with a surface opposite in the Z direction that protrudes from the member 8a1. In the present embodiment, the member 8a2 and the cover member 2 are adhered via an adhesive layer.

The sidewall member 8b is a frame-shaped member provided in the Z direction of the sidewall member 8a, and is disposed to surround the display panel 3 and the backlight unit 4 in the present embodiment. In the present embodiment, a surface of the sidewall member 8b opposite in the Z direction is adhered to the sidewall member 8a via an adhesive layer.

The shapes of the sidewall members 8a and 8b are not limited to those described above, and may be any shape. In the present embodiment, although the two sidewall members 8a and 8b are provided as the sidewall member 8, the configuration of the sidewall member 8 is not limited thereto, and may be any configuration. For example, the sidewall member 8 may be constituted by one member, or may be constituted by three or more members.

The Young's modulus of the sidewall member 8 is preferably 1 GPa or more and 250 GPa or less, and more preferably 2 GPa or more and 20 GPa or less. The Young's modulus is preferably 1 GPa or more, and more preferably 2 GPa or more. The Young's modulus is also preferably 250 GPa or less, and more preferably 20 GPa or less. In the case where the sidewall member 8 is constituted by a plurality of members, it is preferable that the Young's modulus of each member falls within the above range.

As a material of the sidewall member 8, for example, a metal (simple substance) or an alloy containing a metal element such as aluminum or magnesium is preferred. The material of the sidewall member 8 may be resin or a laminate of a resin layer and a metal layer. In the case where the sidewall member 8 is constituted by a plurality of members, each member may be made of a different material.

In the present embodiment, although the sidewall member 8 is a member separate from the bottom member 5, the present invention is not limited thereto, and the sidewall member 8 and the bottom member 5 may be an integrated member. In addition, for example, among the plurality of members constituting the sidewall member 8, a part of the members may be integrated with the bottom member 5, and some other members may be separated from the bottom member 5. That is, for example, the sidewall member 8b may be integrated with the bottom member 5, and the sidewall member 8a may be separated from the bottom member 5.

Although the display device 1 of the present embodiment is configured as described above, the display device 1 is not limited to those described above and may have any configuration. For example, the display device 1 may have a configuration in which, with the cover member 2 as a first layer, arbitrary members up to an n-th layer except for the bottom member are disposed on a virtual line D, which will be described later. In addition, for example, although the bottom member 5 is disposed most in the Z direction among the members of the display device 1 in the example of the present embodiment, the present invention is not limited thereto, and for example, a member may be provided further in the Z direction than the bottom member 5. That is, even in the case where there is another member further disposed in the Z direction than the bottom member 5, a layer (bottom member 5) on which the fixing point P is formed is treated as the bottom member in the present embodiment. In other words, the layer on which the fixing point P is formed and which is disposed most in the Z direction is treated as the bottom member 5.

(2. Fixed State of Display Device)

Next, a state in which the display device 1 is fixed to the interior portion 10 of a vehicle will be described. Hereinafter, fixing of the display device 1 will be described. FIG. 4 is a schematic diagram of the display device viewed from a display surface, and FIG. 5 is a cross-sectional view taken along line B-B in FIG. 1.

(Fixing Point)

As described above, the fixing point P to be fixed to the interior portion 10 is formed on the main surface 5A of the bottom member 5 of the display device 1 in the Z direction. In the present embodiment, a plurality of fixing points P are provided, and in the example of FIG. 4, four fixing points P1, P2, P3, and P4 are provided. The fixing points P1 and P2 are disposed in the X direction (a width direction of the vehicle in the case where the display device 1 is attached to a vehicle). The fixing points P3 and P4 are positioned in a direction opposite to the Y direction with respect to the fixing points P1 and P2 (on a lower side in the vertical direction in the case where the display device 1 is attached to a vehicle), and are disposed in the X direction. A line passing through the fixing points P1 and P2 and a line passing through the fixing points P3 and P4 are parallel to each other, and the fixing points P1 to P4 form four vertices of a rectangle.

As illustrated in FIGS. 1, 2, 4, and 5, the bracket 9 as a fixing member may be attached to the fixing point P. In this case, the bottom member 5 is fixed to the interior portion 10 via the bracket 9. In the example of the present embodiment, as illustrated in FIG. 4, a bracket 91 is attached to the fixing point P1, a bracket 92 is attached to the fixing point P2, a bracket 93 is attached to the fixing point P3, and a bracket 94 is attached to the fixing point P4.

As illustrated in FIG. 5, the bracket 9 is a long plate-shaped member and is bent in a U-shape. A center of the bracket 9 in a plate width direction is positioned at the fixing point P. In the bracket 9, one side of the end of the convex surface 9a (a surface opposite to the Y direction in FIG. 5) formed by being bent in a U-shape is in contact with the fixing point P. A direction perpendicular to the convex surface 9a of the bracket 9 intersects perpendicularly with the X direction (the width direction of the vehicle). In the bracket 9, one surface 9b connected to the convex surface 9a is in contact with the bottom member 5, and the other surface 9c connected to the convex surface 9a is in contact with the interior portion 10. That is, the position on the main surface 5A of the bottom member 5 overlapping the midpoint of the one side of the end of the convex surface 9a of the bracket 9 (that is, the midpoint in the X direction of the side of the contact region opposite to the Y direction) is the fixing point P. The bracket 9 is fixed to the bottom member 5 and the interior portion 10 with, for example, a screw (not illustrated). The shape of the bracket 9 is not limited to that described above, and may be bent in an S-shape, for example.

Since the display device 1 is attached to a vehicle via the bracket 9 as described above, it can be said that the display device 1 and the bracket 9 constitute a display device unit.

The bottom member 5 may be fixed to the interior portion 10 by, for example, deforming a part of the bottom member 5 without using the bracket 9. Alternatively, a part of the interior portion 10 may be deformed and fixed to the bottom member 5. In these cases, each fixing point P may be defined as a center of each fixing portion.

The positions and the number of the fixing points P are not limited to those described above. A plurality of fixing points P may be formed in any number, and each fixing point P in this case may be at any position.

(Intermediate Point PQ)

In the following, an intermediate point PQ is defined to explain the position ($YH/YH_{cg}$ which will be described later) of the fixing point P in the Y direction with respect to the display device 1. The intermediate point PQ is a midpoint between the fixing point P1 and the fixing point P2. When a distance between the intermediate point PQ and the fixing point P1 (or a distance between the intermediate point PQ and the fixing point P2) is defined as a distance X, the distance X is preferably 30 mm or more and 200 mm or less, and more preferably 50 mm or more and 130 mm or less, from the viewpoint of vibration characteristics (JIS D 1601: 1995 vibration test method for automobile parts). The distance X is preferably 30 mm or more, and more preferably 50 mm or more. The distance X is also preferably 200 mm or less, and more preferably 130 mm or less. When a distance between the fixing point P1 and the fixing point P3 disposed in the Y direction (or a distance between the fixing point P2 and the fixing point P4) is defined as a distance Y, the distance Y is preferably 30 mm or more and 200 mm or less, and more preferably 35 mm or more and 125 mm or less for the same reason. The distance Y is preferably 30 mm or more, and more preferably 35 mm or more. The distance Y is also preferably 200 mm or less, and more preferably 125 mm or less.

Since the fixing points P have any number and positions as described above, the definition of the intermediate point PQ for each variation of the positions of the fixing points P will be described below.

Among the fixing points P provided on the bottom member 5, two fixing points P are selected from the Y direction (an upper side in the vertical direction), and a midpoint between the two selected fixing points P is set as an intermediate point PQ. For example, FIGS. 1 to 5 illustrate an example in which the bottom member 5 is fixed to the interior portion 10 at four fixing points P (fixing points P1 to P4) disposed two by two in the Y direction. As illustrated in FIGS. 1 to 5, in the case where there are a plurality of fixing points P in the Y direction, two fixing points (the fixing point P1 and the fixing point P2 in FIGS. 1 to 4) most in the Y direction are used as the fixing points P for defining the intermediate point PQ (and a virtual plane R which will be described later).

In the case where there are three or more fixing points P at the same position (the same height) in the Y direction, two fixing points P having the smallest interval therebetween are selected, and a midpoint therebetween is set as the intermediate point PQ. In the case where there are three or more fixing points equally spaced at the same position in the Y direction, a midpoint between any two fixing points P may be set as the intermediate point PQ. That is, in the case where there are a plurality of candidates for the intermediate point PQ (and the virtual plane R which will be described later), any one of the candidates may satisfy the requirements of the present embodiment.

The bottom member 5 may be fixed to the interior portion 10 at three fixing points P. For example, when explaining by referring to FIG. 4, it is assumed that the fixing point P1 and the fixing point P2 are not present and, instead, another fixing point P' (not illustrated in FIG. 4 and the like) is present on a line connecting the fixing point P1 and the fixing point P2. In this case, the bottom member 5 is fixed to the interior portion 10 at three points of the fixing point P3, the fixing point P4, and the fixing point P'. At this time, in the case where there is no difference in position (height) in the Y direction between the fixing point P3 and the fixing point P4, the fixing point closer to the fixing point P' is selected, and a midpoint between the selected fixing point and the fixing point P' is set as the intermediate point PQ. In the case where there is no difference in distance from the fixing point P', either the fixing point P3 or the fixing point P4 is selected, and a midpoint between the selected fixing point and the fixing point P' is set as the intermediate point PQ. In the case where the fixing point P3 and the fixing point P4 are positioned at different positions in the Y direction, two fixing points P (the fixing point P' and the fixing point further disposed in the Y direction among the fixing point P3 and the fixing point P4) are selected from the Y direction, and a midpoint between the selected fixing points is set as the intermediate point PQ, similarly to the definition for four fixing points P.

($YH/YH_{cg}$)

As illustrated in FIG. 4, a plane that passes through the intermediate point PQ and is perpendicular to the line connecting the fixing point P1 and the fixing point P2 (two fixing points P used to define the intermediate point PQ) is defined as the virtual plane R. As illustrated in FIG. 5, a length of an intersection line between the cover member 2 and the virtual plane R is defined as the distance $YH_{cg}$. In addition, as illustrated in FIG. 5, a length of an intersection line between the main surface of the display panel 3 and the virtual plane R from the upper end of the display panel 3 (the end portion in the Y direction) to a point corresponding to the intermediate point PQ is defined as a distance YH. The "point corresponding to the intermediate point PQ" is a point where the intermediate point PQ is moved in the thickness direction (Z direction) of the display device 1 and is positioned on the main surface of the display panel 3.

In the display device 1, the position of the fixing point P is set so that the ratio $YH/YH_{cg}$ of the distance YH to the distance $YH_{cg}$ is 0.5 or less. That is, it can be said that the display device 1 is a display device of an "in-dash type or on-dash type (hereinafter, also simply referred to as "in-dash type")" in which the vicinity of the upper end is also fixed to the interior portion 10. In the display device 1, the ratio $YH/YH_{cg}$ is preferably 0.1 or more and 0.5 or less, and more preferably 0.3 or more and 0.5 or less. The ratio $YH/YH_{cg}$ is preferably 0.1 or more, and more preferably 0.3 or more.

In the case where the ratio $YH/YH_{cg}$ is greater than 0.5, it can be said that the display device 1 corresponds to a "standing type" in which only a lower end of the bottom member is fixed to the dashboard.

The display device 1 is fixed to a vehicle as described above.

(3. Configuration for Reducing Damage to Cover Member)

In the in-vehicle display device, the way an impact is transmitted to the cover member changes depending on a state in which the display device is fixed to the vehicle, and it is also required to reduce the damage to the cover member 2 in the in-dash type display device 1 as in the present embodiment. In particular, it is required to impart excellent impact resistance (hereinafter, referred to as "end portion impact resistance") to end portions of the cover member 2 as evaluated in a head impact test. Hereinafter, a configuration for reducing damage by improving the end portion impact resistance of the cover member 2 will be described.

(Equidistance Point H0 and Reference Point H)

An equidistance point H0 and a reference point H are defined to explain the improvement of the end portion impact resistance of the cover member 2. As illustrated in FIG. 4, on the corner 2D of the cover member 2 in the Y direction, when viewed from the Z direction, a position where a distance from each of the two fixing points P used to define the intermediate point PQ is equal is defined as the equidistance point H0. In the example of the present embodiment, since the fixing points P1 and P2 are used to define the intermediate point PQ, it can be said that the equidistance point H0 is a point where a distance from the fixing point P1 is equal to a distance from the fixing point P2 on the corner 2D of the cover member 2 in the Y direction, when viewed from the Z direction. That is, in the example of the present embodiment, a distance L1 from the equidistance point H0 to the fixing point P1 when viewed from the Z direction is equal to a distance L2 from the equidistance point H0 to the fixing point P2 when viewed from the Z direction.

In an extending direction (the X direction in the example of FIG. 4) of the corner 2D of the cover member 2 in the Y direction, positions on the corner 2D separated from the equidistance point H0 by a predetermined distance D1 are taken as points H1 and H2. That is, in the example of FIG. 4, the point H1 is a position on the corner 2D separated from the equidistance point H0 by the predetermined distance D1 in a direction opposite to the X direction, and the point H2 is a position on the corner 2D separated from the equidistance point H0 by the predetermined distance D1 in the X direction. In this case, the reference point H is set as arbitrary position between the point H1 and the point H2 on the corner 2D of the cover member 2 in the Y direction. That is, it can be said that the reference point H is a position on the corner 2D between a position (the point H1 in the example of FIG. 4) separated by the predetermined distance D1 from the equidistance point H0 in one direction (the direction opposite to the X direction in the example of FIG. 4) in the extending direction of the corner 2D and a position (the point H2 in the example of FIG. 4) separated by the predetermined distance D1 in one direction (the X direction in the example of FIG. 4) in the extending direction of the corner 2D. The predetermined distance D1 may be freely set, and may be, for example, 18 mm.

The reference point H may be any position between the point H1 and the point H2 on the corner 2D in the Y direction, and is preferably a position where the rigidity becomes minimum among positions between the point H1 and the point H2 on the corner 2D in the Y direction. In the example of the present embodiment, since among the positions between the point H1 and the point H2, the position where the rigidity becomes minimum is the equidistance point H0, the equidistance point H0 is treated as the reference point H. The position where the rigidity becomes minimum refers to a position where $(E_{cg} \cdot t^2 + ... + E_n \cdot t_n^2)$ in Formula (2), which will be described later, becomes minimum among the positions between the point H1 and the point H2.

The reference point H is not limited to the position where the rigidity becomes minimum between the point H1 and the point H2. For example, the equidistance point H0 may be treated as the reference point H without considering the rigidity.

The reference point H may be, for example, a position of a hitting point where an impactor collides in the head impact test.

(Virtual Line D)

Next, the virtual line D is defined. FIG. 6 is a cross-sectional view taken along line C-C in FIG. 4. The C-C cross section is a cross section passing through the reference point H and along the Y direction. As illustrated in FIG. 6, a virtual line that passes through the reference point H and the bottom member 5 and is inclined at an angle θ with respect to the Z direction is defined as the virtual line D. That is, it can be said that the virtual line D passes through the reference point H and is inclined inward in the radial direction by the angle θ with respect to the Z direction. The radial direction refers to a radial direction when the central axis of the cover member 2 passing through the Z direction is taken as the axial direction. As described above, the central axis of the cover member 2 is an axis that passes through the center point of the cover member 2 when viewed from the Z direction and extends in the Z direction. In the present embodiment, the angle θ is 30° or more and 45° or less. It can be said that the virtual line D corresponds to a direction in which a high impact is transmitted when an impact is applied to the corner 2D in the head impact test or the like.

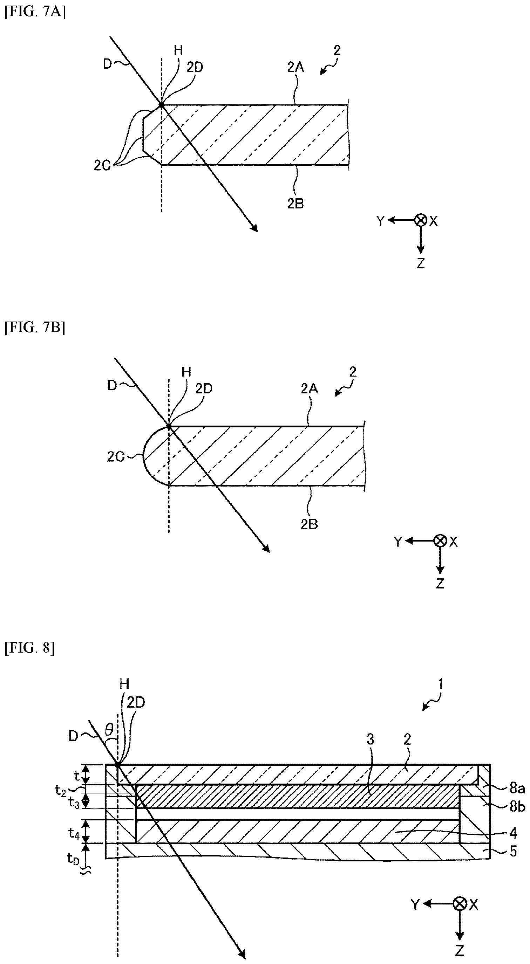

FIGS. 7A and 7B are partially enlarged schematic diagrams of another example of the cover member. As illustrated in FIG. 7A, in the cover member 2, a boundary portion between the first main surface 2A and the second main surface 2B may be chamfered. The end surface 2C of the chamfered cover member 2 is, for example, as illustrated in FIG. 7A, a surface bent in stages in a cross-sectional view. In the chamfered cover member 2 as well, a corner formed by the first main surface 2A and the end surface 2C is defined as the corner 2D, and a virtual line passing through the reference point H on the corner 2D is defined as the virtual line D. As illustrated in FIG. 7B, in the cover member 2, a boundary portion between the first main surface 2A and the second main surface 2B may be subjected to round-chamfering. The end surface 2C of the round-chamfered cover member 2 has a curved (curved surface) shape with a predetermined curvature radius in a cross-sectional view. In the round-chamfered cover member 2 as well, a corner formed by the first main surface 2A and the end surface 2C having a curved surface shape is defined as the corner 2D, and a virtual line passing through the reference point H on the corner 2D is defined as the virtual line D. The end surface 2C of the round-chamfered cover member 2 may have a constant curvature radius or may have a spline shape in which the curvature radius is different for each position.

(Layer Configuration on Virtual Line D)

In the display device 1, members up to the n-th layer are disposed on the virtual line D defined as described above with the cover member 2 as the first layer, except for the bottom member 5. In addition, n is an integer of 2 or more. That is, it can be said that in the display device 1, the cover member 2, members of (n-1) layers other than the cover member 2 and the bottom member 5, and the bottom member 5 are disposed along the virtual line D.

In the example of FIG. 6, in the display device 1, the cover member 2 which is a first layer and has the thickness t, the sidewall member 8a which is a second layer and has a thickness $t_2$, the sidewall member 8b which is a third layer and has a thickness $t_3$, and the bottom member 5 are disposed in this order along the virtual line D, and in this example, n = 3.

The layer configuration on the virtual line D illustrated in FIG. 6 is an example. FIG. 8 is a schematic diagram illustrating another example of a cross section of the display device. In the example of FIG. 8, in the display device 1, the cover member 2 which is a first layer, the sidewall member 8a which is a second layer, the display panel 3 which is a third layer, the backlight unit 4 which is a fourth layer, and the bottom member 5 are disposed in this order along the virtual line D, and in this example, n = 4.

The number represented by n, that is, the total number of the cover member 2 and the members other than the bottom member 5 on the virtual line D is preferably 2 to 20, more preferably 3 to 20, and still more preferably 4 to 10. The number represented by n is preferably 2 or more, more preferably 3 or more, and still more preferably 4 or more. The number represented by n is also preferably 20 or less, and more preferably 10 or less.

(Relation between Layers on Virtual Line D)

The present inventors have found that in the case where each layer on the virtual line D satisfies the following Formula (1) on the virtual line D, the end portion impact resistance of the cover member 2 can be improved to reduce the damage.

[Math. 3]

$$Q \leqq 109.17t^2 - 165.5t + 94.058 \qquad \text{... Formula (1)}$$

In Formula (1), t is the thickness (mm) of the cover member 2 in the Z direction, and Q is a value obtained by the following Formula (2).

[Math. 4]

$$Q = E_D \cdot t_D^2 / (Ecg \cdot t^2 + \cdots + E_n \cdot t_n^2)/100 \qquad \text{... Formula (2)}$$

In Formula (2), $E_D$ is the Young's modulus (GPa) of the bottom member 5, $E_n$ is the Young's modulus (GPa) of the member of the n-th layer, and $t_n$ is a thickness (mm) of the member of the n-th layer in the Z direction at a region through which the virtual line D passes. That is, it can be said that $t_n$ is a length in the Z direction from a position closer to the cover member 2 (most opposite in the Z direction) in the Z direction through which the virtual line D passes in the member of the n-th layer to a position opposite to the cover member 2 (most in the Z direction) in the Z direction through which the virtual line D passes in the member of the n-th layer. Taking the sidewall member 8a which is the second layer in FIG. 6 as an example, the thickness $t_2$ of the sidewall member 8a is a length in the Z direction from a point PA1 of the sidewall member 8a which is the most opposite in the Z direction and through which the virtual line D passes to a point PA2 of the sidewall member 8a which is the most in the Z direction and through which the virtual line D passes.

In Formula (2), $t_D$ is a value obtained by the following Formula (3). That is, it can be said that to is a value corresponding to a thickness of a virtual bottom member having only a plate portion without ribs and having the same second moment of area as the bottom member 5 having the rib 7.
[Math. 5]

$$t_D = \sqrt[3]{a^3 + \frac{w_2}{w_1}h^3 + 12a\left(b - \frac{a}{2}\right)^2 12\frac{w_2}{w_1}h\left(\frac{h}{2} + a - b\right)^2} \qquad \text{... Formula (3)}$$

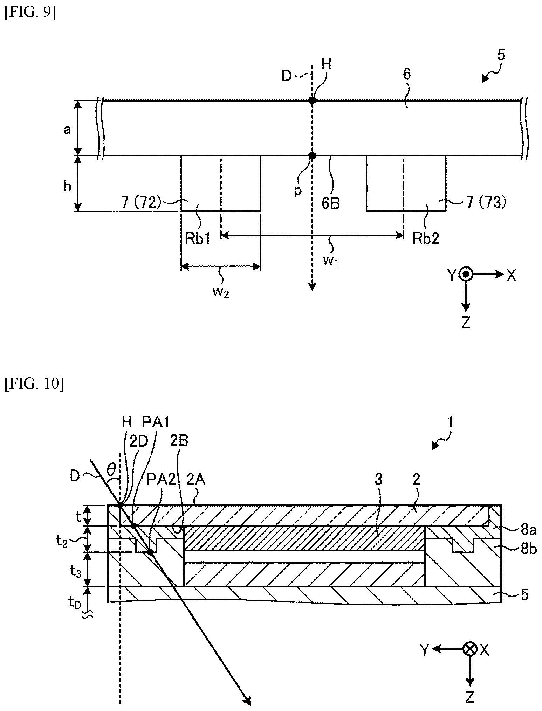

FIG. 9 is a schematic partially enlarged view of the bottom member.

In Formula (3), a is a thickness (mm) of the plate portion 6 of the bottom member 5 in the Z direction as illustrated in FIG. 9, $w_2$ is a width (mm) of a first rib Rb1 as illustrated in FIG. 9, $w_1$ is a distance (mm) between the first rib Rb1 and a second rib Rb2 as illustrated in FIG. 9, and h is a thickness (mm) of the first rib Rb1 and the second rib Rb2 in the Z direction as illustrated in FIG. 9.

The first rib Rb1 is the rib 7 closest to a point p on the main surface 6B of the plate portion 6 through which the virtual line D passes, among the ribs 7 of the bottom member 5. The second rib Rb2 is the rib 7 that is positioned on a line connecting the point p on the plate portion 6 through which the virtual line D passes and the first rib Rb1 and is closest to the first rib Rb1. In other words, the second rib Rb2 is a rib positioned in an extending direction of a line passing through the first rib Rb1 and the point p on the plate portion 6 through which the virtual line D passes and perpendicular to a center line of the first rib Rb1.

The width of the first rib Rb1 refers to the width of the first rib Rb1 when viewed from the extending direction of the first rib Rb1. The distance between the first rib Rb1 and the second rib Rb2 refers to a distance between a central axis of the first rib Rb1 and a central axis of the second rib Rb2 when viewed from the extending direction of the first rib Rb1. Further, it can be said that the distance between the first rib Rb1 and the second rib Rb2 is referred to as a distance between the first rib Rb1 (rib 73) and the second rib Rb2 (rib 75) (a distance between the center lines) on a perpendicular line of the first rib Rb1 (the rib 73) passing through the point p. In the case where the first rib Rb1 and the second rib Rb2 have different thicknesses in the Z direction, h may be an average value of the thicknesses of the first rib Rb1 and the second rib Rb2 in the Z direction.

In Formula (3), b is represented by the following Formula (4). In Formula (4), a, $w_1$, $w_1$, and h are the same as a, $w_2$, $w_1$, and h in Formula (3), respectively.
[Math. 6]

$$b = \frac{0.5w_1 \cdot a^2 + 0.5w_2 \cdot h^2 + w_2 \cdot a \cdot h}{w_1 \cdot a + w_2 \cdot h} \qquad \text{... Formula (4)}$$

In the case where the display device 1 satisfies Formula (1) described above, it is possible to improve the end portion impact resistance of the cover member 2. It can be said that the numerator of Q ($E_D \cdot t_D^2$) corresponds to the rigidity of the bottom member 5, and that the denominator of Q ($E_{cg} \cdot t_2 + ... E_n \cdot t_n^2$) corresponds to a total value of the rigidity of the members passing through the virtual line D excluding the bottom member 5. Therefore, it can be said that Q is a value indicating a ratio of the rigidity of the bottom member 5 to the total value of the rigidity of the members passing through the virtual line D excluding the bottom member 5. Therefore, by setting the ratio of the rigidity of the bottom member 5 according to the thickness t of the cover member 2 as shown in Formula (1), the end portion impact resistance of the cover member 2 can be improved.

Q obtained by Formula (2) is preferably 1.5 or more. In the case where a lower limit value of Q falls within this range, the rigidity of the bottom member 5 can be ensured, and the damage to the housing of the display device 1 can be suitably reduced.

In addition, $t_D$ is preferably 1 mm or more and 3 mm or less, more preferably 1.5 mm or more and 2.5 mm or less, and still more preferably 2 mm or more and 2.5 mm or less.

When a member on the virtual line D other than the cover member 2 and the bottom member 5 is defined as a member of an m-th layer, the Young's modulus $E_m$ of the member of the m-th layer is preferably 1 GPa or more and 280 GPa or less, more preferably 45 GPa or more and 250 GPa or less, and still more preferably 70 GPa or more and 210 GPa or less. The thickness $t_m$ of the member of the m-th layer is preferably 1 mm or more, more preferably 2 mm or more, and still more preferably 3 mm or more. The thickness $t_m$ of the member of the m-th layer is, for example, 50 mm or less.

In the case where these parameters fall within the above respective numerical ranges, Q can be set to an appropriate value to improve the end portion impact resistance of the cover member 2.

A member through which the virtual line D passes other than the cover member 2 and the bottom member 5 may also have a rib in the Z direction. In this case as well, as a thickness of this member in the Z direction (for example, the thickness $t_n$ of the n-th layer), the length in the Z direction from the position which is the most opposite in the Z direction and through which the virtual line D passes to the position which is the most in the Z direction and through which the virtual line D passes is used as described for $t_n$ without applying Formula (3) or Formula (4). FIG. 10 is a schematic cross-sectional view of a display device according to another example of the present embodiment. That is, for example, as illustrated in FIG. 10, in the case where there is a rib on a surface of the sidewall member 8a, which is a member of a second layer, in the Z direction, and the rib overlaps the virtual line D, a length in the Z direction from a point PA1 where a surface of the sidewall member 8a opposite in the Z direction overlaps the virtual line D to a point PA2 where a surface of the rib of the sidewall member 8a in the Z direction overlaps the virtual line D is the thickness $t_2$ of the sidewall member 8a.

As for the bottom member 5, regardless of whether the virtual line D passes through the rib 7, $t_D$ is the value obtained by using Formula (3) or (4).

As described above, the members on the virtual line D, corresponding to the second layer to the n-th layer in Formula (2) are members other than the cover member 2 and the bottom member 5, provided in the display device 1 and overlap the virtual line D. In the present embodiment, in the case where a member having a low Young's modulus and a small thickness is on the virtual line D, the member may be treated as not existing in Formula (2). In other words, for a member having a low Young's modulus and a small thickness, the value of "$E_n \cdot t_n 2$" may be regarded as 0 (zero). Specifically, in the case where a member having a Young's modulus of 0.5 GPa or less and a thickness in the Z direction of 1 mm or less is on the virtual line D, it is preferable to consider that this member does not exist in Formula (2). In other words, in the present embodiment, a member having a Young's modulus greater than 0.5 GPa, having a thickness in the Z direction greater than 1 mm, and overlapping the virtual line D is treated as a member on the virtual line D corresponding to the second layer to the n-th layer.

Examples of the layer regarded as not existing in Formula (2) include an adhesive layer that adheres members of the display device 1 together, a thin film layer, and a resin layer. For example, a thin film layer such as an anti-reflection (AR) layer or an anti-finger-print (AFP) layer may be formed on a surface of the cover member 2, or a resin film on which an AR layer, an AFP layer, an AG layer, or the like is formed may be attached. The display panel 3 may include a thin film layer such as a TFT or a transparent conductor. However, these thin film layers are extremely thinner than, for example, the cover member 2 itself or a glass substrate (soda lime glass or the like) constituting the display panel 3. The backlight unit 4 or the like may have a resin layer, but the Young's modulus of the resin layer is extremely small. Therefore, when these thin film layers and the resin layer are assumed to be an "m-th layer", the value of "$E_m \cdot t_m 2$" may be regarded as 0 (zero).

Examples of a configuration of a display device having a thin film layer include a configuration including a cover glass, an OCA, a polarizing plate, a color filter, a liquid crystal, a TFT substrate, a polarizing plate, a brightness enhancement film, a lens sheet, a diffusion plate, a light guide plate, a reflection film, a backlight unit case, a printed wiring board, a bottom member, and a housing resin cover.

In FIG. 9, a is preferably 0.5 mm to 6 mm, and more preferably 1 mm to 5 mm. From the viewpoint of productivity, the value of a is preferably 0.5 mm or more, and more preferably 1 mm or more. From the viewpoint of weight reduction, a is preferably 6 mm or less, and more preferably 5 mm or less.

In FIG. 9, h may be 0 mm, preferably 1 mm to 20 mm, and more preferably 2 mm to 10 mm. From the viewpoint of obtaining a rigidity-increasing effect by the rib 7, the value of h is preferably 1 mm or more, and more preferably 2 mm or more. From the viewpoint of ease of production of the bottom member 5 and from the viewpoint of preventing excessive enlargement of size of the bottom member 5, h is preferably 20 mm or less, and more preferably 10 mm or less.

In FIG. 9, $w_1$ is preferably 1 mm to 40 mm, and more preferably 2 mm to 30 mm. From the viewpoint of ease of production of the bottom member 5, $w_1$ is preferably 1 mm or more, and more preferably 2 mm or more. From the viewpoint of effectively preventing the generation of stress in the cover member 2 in a head impact test, $w_1$ is preferably 40 mm or less, and more preferably 30 mm or less.

In FIG. 9, $w_2$ is preferably 1 mm to 20 mm, and more preferably 3 mm to 15 mm. From the viewpoint of ease of production of the bottom member 5 and from the viewpoint of obtaining the rigidity-increasing effect by the rib 7, $w_2$ is preferably 1 mm or more, and more preferably 3 mm or more. From the viewpoint of obtaining a weight reduction effect of the display device 1, $w_2$ is preferably 20 mm or less, and more preferably 15 mm or less.

(4. Other Examples)

Next, other examples of the present embodiment will be described.

(Example in which an intermediate member has a rib on a side opposite in the Z direction)

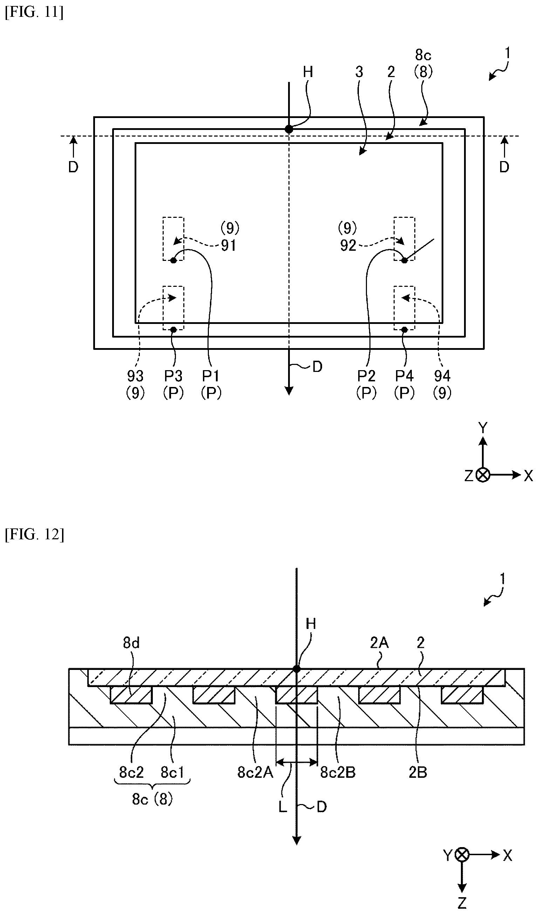

FIG. 11 is a schematic diagram of a display device according to another example of the present embodiment, and FIG. 12 is a cross-sectional view taken along line D-D in FIG. 11. At least one of the members (intermediate members) other than the cover member 2 and the bottom member 5 on the virtual line D may have a rib on a surface opposite in the Z direction. In this case, in order to more appropriately improve the end portion impact resistance of the cover member 2, in addition to the value of Q, it is preferable to set a value of Q' in consideration of the presence of the rib within a preferable range. Hereinafter, as illustrated in FIGS. 11 and 12, a case where a sidewall member 8c is provided as the sidewall member 8 and the sidewall member 8c has a rib will be described as an example.

As illustrated in FIG. 12, the sidewall member 8c includes a base portion 8c1 and ribs 8c2. The base portion 8c1 is a frame-shaped member surrounding the cover member 2 and the display panel 3. The ribs 8c2 are members that protrude from a surface of the base portion 8c1 opposite in the Z direction. In the example of FIG. 12, the ribs 8c2 extend along the Y direction, and a plurality of the ribs 8c2 are disposed along the X direction. Surfaces of the ribs 8c2 opposite in the Z direction are adhered to the second main surface 2B of the cover member 2 in the Z direction via, for example, an adhesive layer. Although a resin layer 8d is filled between the ribs 8c2, the present invention is not limited thereto, and a cavity in which nothing is filled may be formed. The adhesive layer and the resin layer 8d may not be treated as members on the virtual line D.

Among the plurality of ribs 8c2, two ribs 8c2 having the shortest distance from the reference point H are defined as a first rib 8c2A and a second rib 8c2B. It can be said that the first rib 8c2A is a rib having the shortest distance from the reference point H among the ribs 8c2 in a direction opposite to the X direction with respect to the reference point H, and that the second rib 8c2B is a rib having the shortest distance from the reference point H among the ribs 8c2 in the X direction with respect to the reference point H. Hereinafter, the distance between the first rib 8c2A and the second rib 8c2B is defined as a distance L.

In the case where there is a rib on a surface of the intermediate member opposite in the Z direction as in the present example, it is preferable that the value of Q' obtained by the following Formula (5) further satisfies the following Formula (1)'.

Symbols in the formulas have the same meaning as the symbols in the above Formula (1) and Formula (2).

[Math. 7]

$$Q' \leq 109.17t^2 - 165.5t + 94.058 \qquad \cdots \text{Formula (1)'}$$
$$Q' = E_D \cdot t_D{}^2 / (Ecg \cdot t^2 + \cdots + E_n \cdot t_n{}^2) \times (L/2)^3 / 100 \qquad \cdots \text{Formula (5)}$$

Formula (5) is different from Formula (2) in that "$(L/2)^3$" is multiplied. That is, in the case where there is a rib on the surface of the intermediate member opposite in the Z direction, since the cover member 2 is supported by the rib, it is assumed that the cover member 2 is more likely to be damaged. On the other hand, as Q', Q is multiplied by "$(L/2)^3$" to take the influence in the case of being supported by the rib into account. In the case where Q' satisfies Formula (1)', damage to the cover member 2 can be suitably reduced even in the case where there is a rib. The value of L in Formula (5) becomes the same as Formula (2) by setting the value of L to "2". Therefore, for example, Formula (5) may be applied without using Formula (2), regardless of whether there is a rib, and in the case where there is no rib, the value of L may be set to "2".

In the above description, although an example in which a rib is provided on one of the members (intermediate members) other than the cover member 2 and the bottom member 5 on the virtual line D has been described, the ribs may be formed on surfaces of a plurality of intermediate members opposite in the Z direction. In this case, as the value of L in Formula (5), among the plurality of intermediate members on which ribs are formed, the value of L of the intermediate member disposed most in the Z direction (closest to the cover member 2) is applied.

In the example of FIG. 12, although the base portion has a frame shape as the sidewall member 8c is taken as an example, the base portion is not limited to the frame shape and may have any shape. For example, the base portion may be a flat plate-shaped member. The shape, the number, and the arrangement of the ribs are not limited to those in the example of FIG. 12, and may be any shape, number, and arrangement.

L is preferably 10 mm or more and 20 mm or less, more preferably 10 mm or more and 18 mm or less, and still more preferably 13 mm or more and 18 mm or less. L is preferably 10 mm or more, and more preferably 13 mm or more. L is also preferably 20 mm or less, and more preferably 18 mm or less.

In the case where L falls within the above numerical ranges, Q' can be set to an appropriate value to improve the end portion impact resistance of the cover member 2.

(Example in which there is one fixing point)

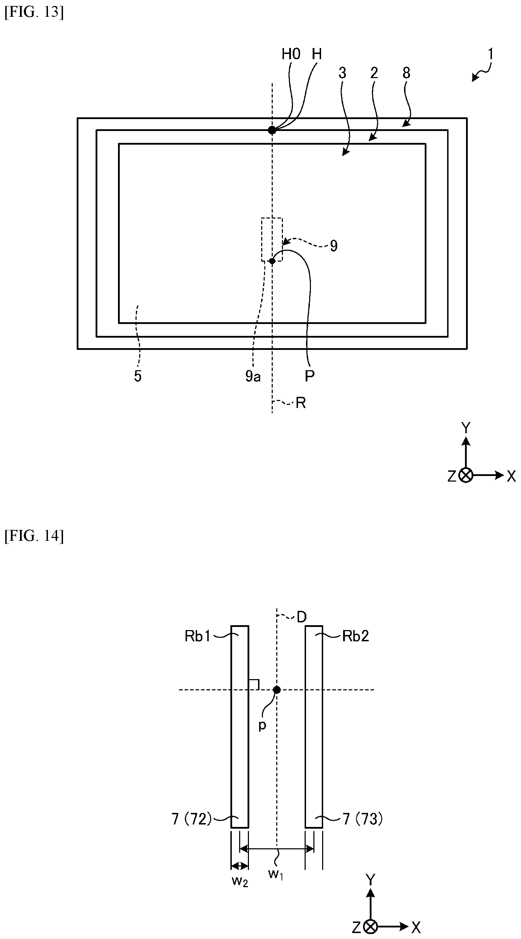

In the above description of the embodiment, although a plurality of fixing points P are formed, but the number of fixing points P may be one. The definitions of the virtual plane R and the reference point H in the case where there is one fixing point P are different from those in the case where there are a plurality of fixing points P, and this will be described below. FIG. 13 is a schematic diagram of a display device according to another example of the present embodiment.

As illustrated in FIG. 13, the bottom member 5 is fixed to a vehicle at one fixing point P. In the example of FIG. 13, the bottom member 5 is fixed to the bracket 9 at the one fixing point P, thereby being fixed to the vehicle via the bracket 9.

In this way, in the case where there is one fixing point P, a virtual plane perpendicular to a side, which is in contact with the bottom member 5, of the convex surface 9a of the bracket 9 disposed at the one fixing point P, is defined as the virtual plane R for defining the distance YH and the distance $YH_{cg}$ (see FIG. 4). A virtual plane that passes through the fixing point P and extends along the thickness direction (Z direction) of the cover member 2 at the fixing point P and the vertical direction (Y direction) when the cover member 2 is mounted on the vehicle may be defined as the virtual plane R.

In this way, in the case where there is one fixing point P, as illustrated in FIG. 13, a position where a distance from the fixing point P is the shortest when viewed from the Z direction on the corner 2D of the cover member 2 in the Y direction is defined as the equidistance point H0. A method for defining the reference point H based on the equidistance point H0 is the same as that in the above embodiment, and thus the description thereof will be omitted. In the example of FIG. 13, the position of the equidistance point H0 is the reference point H.

As described above, the definitions of the virtual plane R and the reference point H in the case where there is one fixing point P are different from those in the case where there are a plurality of fixing points P. However, the other points may be treated as the same. That is, it can be said that even in the case where there is one fixing point P, it is preferable that the display device 1 satisfies Formulas (1) to (4). It can be said that even in the case where there is one fixing point P, in the case where there is a rib on the intermediate member, it is preferable to use Formula (5) as the value of Q' in addition to the value of Q.

(Another Example of Rib 7 of Bottom Member 5)

In the above embodiment, although the ribs 7 of the bottom member 5 in the Z direction extends parallel to the Y direction, the shape and arrangement of the ribs 7 are not limited thereto and may be any shape and arrangement. Hereinafter, another example of the shape of the rib 7 will be described.

FIG. 14 is a schematic diagram illustrating positions of ribs of the bottom member in the present embodiment. In the above embodiment, as illustrated in FIGS. 9 and 14, since both the rib 72 and the rib 73 are equidistant from the point p, the first rib Rb1 may be either the rib 72 or the rib 73. However, for convenience, in FIGS. 9 and 14, the rib 72 is referred to as the first rib Rb1.

It can be seen from FIGS. 9 and 14 that $w_2$ is the width of the first rib Rb1 closest to the point p. Further, it can be seen that $w_1$ is the distance between the first rib Rb1 and the second rib Rb2 (the distance between the center lines of the first rib Rb1 and the second rib Rb2).

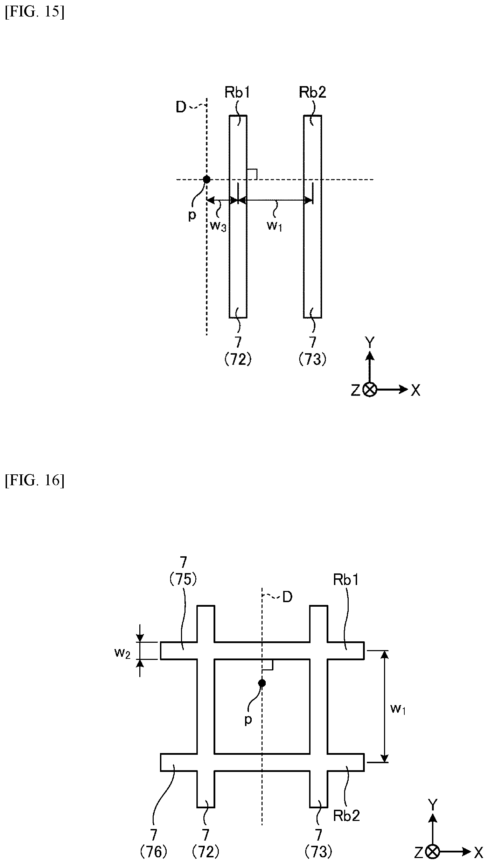

FIG. 15 is a schematic diagram illustrating positions of ribs of a bottom member in another example of the present embodiment. In FIG. 15, the point p (the point corresponding to the reference point H) is not positioned between the rib 72 and the rib 73, but is positioned outside (on a left side of) the rib 72. In FIG. 15, the rib 72 closest to the point p is the first rib Rb1, and the rib 73 positioned on a line connecting the point p and the first rib Rb1 is the second rib Rb2.

The width $w_2$ of the first rib Rb1 and the distance $w_1$ between the first rib Rb1 and the second rib Rb2 are then obtained. Further, a distance $w_3$ between the point p and the first rib Rb1 (a distance from the point p to the center line of the first rib Rb1) is also obtained.

If the distance $w_1$ is equal to or greater than the distance $w_3$ ($w_1 \geq w_3$), Formula (3) and Formula (4) are calculated by using the values of $w_1$ and $w_2$ to obtain the value of $t_n$.

However, if the distance $w_3$ is greater than the distance $w_1$ ($w_3 > w_1$), the values of $w_1$ and $w_2$ are not applied to Formulas (3) and (4), and the calculation is performed on the assumption that there is no rib 7.

FIG. 16 is a schematic diagram illustrating positions of ribs of a bottom member in another example of the present embodiment. FIG. 16 is a schematic diagram illustrating the ribs 7 (ribs 75 and 76) in a lateral direction (X direction) in addition to the ribs 7 (ribs 72 and 73) in a longitudinal direction (Y direction).

In FIG. 16, the first rib Rb1 closest to the point p is the rib 75 in the lateral direction. The second rib Rb2 positioned on the line connecting the point p and the first rib Rb1 is the rib 76 parallel to the rib 75.

As described above, in the case where there are a plurality of ribs 7 (for example, see FIG. 3), only the first rib Rb1 closest to the point p (and the second rib Rb2 corresponding thereto) may be considered.

In the case where there are a plurality of first ribs Rb1 having the same distance from the point p, a relation between the distance $w_1$ and the distance $w_3$ described above is examined for all the first ribs Rb1.

For any one of the first ribs Rb1, if the distance $w_1$ is equal to or greater than the distance $w_3$ ($w_1 \geq w_3$), Formula (3) and Formula (4) are calculated by using the values of $w_1$ and $w_2$ related to this first rib Rb1 to obtain the value of $t_n$.

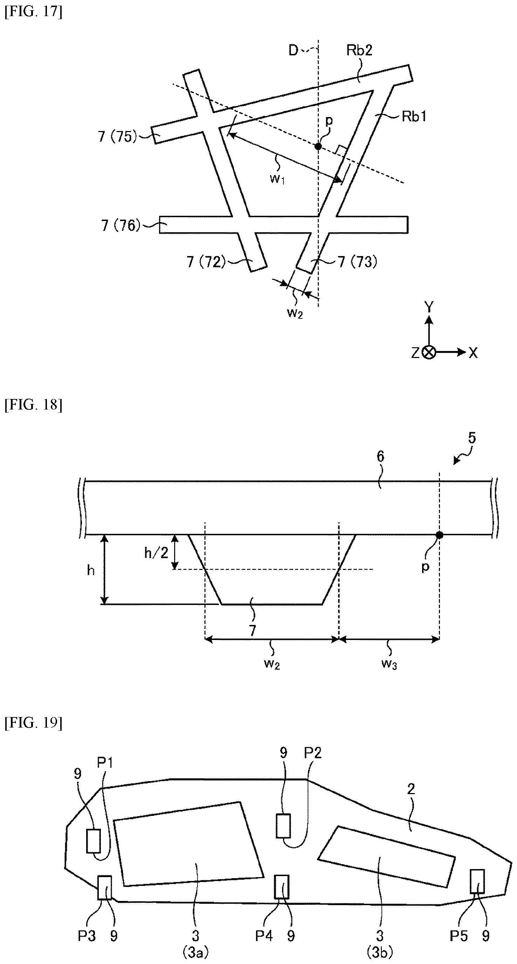

FIG. 17 is a schematic diagram illustrating positions of ribs of a bottom member in another example of the present embodiment. FIG. 17 is a schematic diagram illustrating a state in which the ribs 7 disposed side by side are not parallel to each other. That is, in FIG. 17, the ribs 72 and 73 in the longitudinal direction are not parallel to each other, and the ribs 75 and 76 in the lateral direction are not parallel to each other.

In FIG. 17, the first rib Rb1 closest to the point p is the rib 73. The second rib Rb2 positioned on the perpendicular line of the first rib Rb1 (rib 73) passing through the point p is not the rib 72 but the rib 75.

The width $w_1$ of the first rib Rb1 (the rib 73) and the distance $w_1$ (distance between the center lines) between the first rib Rb1 (the rib 73) and the second rib Rb2 (the rib 75) on the perpendicular line of the first rib Rb1 (the rib 73) passing through the point p are obtained.

As described above, a shape formed by crossing the plurality of ribs 7 may not be a square shape (rectangular shape) with four right-angled corners, and may be a square shape other than a rectangular shape, or other polygons.

In this case as well, the values of $w_1$ and $w_2$ necessary for the calculation of Formulas (3) and (4) can be determined according to the above definitions.

A cross-sectional shape of the rib 7 is, for example, rectangular or trapezoidal. FIG. 18 is a schematic diagram illustrating the rib 7 having a trapezoidal cross-sectional shape. As illustrated in FIG. 18, the above $w_2$ and $w_3$ are values at a height of $h/2$ from a surface (surface on a side where the rib 7 is provided) of the plate portion 6 of the bottom member 5.

(Examples of having a plurality of display panels)

In the above embodiment, although the display device 1 includes one display panel 3, the present invention is not limited thereto, and a plurality of display panels 3 may be provided. In the case where there are a plurality of display panels 3, for each of the display panels 3, values may be calculated based on the above Formulas (1) to (4), or further Formulas (1)' and (5).

FIG. 19 is a schematic diagram of a display device according to another example of the present embodiment. FIG. 19 illustrates only the cover member 2, the display panels 3, and the brackets 9. In FIG. 19, two display panels 3 are attached to one cover member 2, and the bottom member 5 (not illustrated in FIG. 19) is fixed to the interior portion 10 (not illustrated in FIG. 19) by using the brackets 9.

In FIG. 19 as well, two fixing points P1 and P2 are set. Therefore, after the above-described virtual plane R, the ratio $Z/Z_{cg}$, the reference point H, the virtual line D, and the like are determined, the values based on the above Formulas (1) to (5) and (1)' can be calculated.

In FIG. 19, the bracket 9 is disposed outside the display panel 3. As illustrated in FIG. 19, in the case where two fixing points do not exist on a surface of the bottom member 5 facing the display panel 3, fixing points adjacent to an outer periphery of the display panel 3 are considered.

For example, for the display panel 3 (display panel 3a) on a left side in FIG. 19, four points (fixing points P1 to P4) existing outside the display panel 3 are considered as fixing points. Among them, a midpoint between the fixing point P1 and the fixing point P2, which are two fixing points from the top, is defined as the intermediate point PQ. A plane passing through the intermediate point PQ and perpendicular to a line connecting the fixing point P1 and the fixing point P2 is defined as the virtual plane R. A point on the corner 2D at an equal distance from the fixing points P1 and P2 is set as the equidistance point H0.

On the other hand, in FIG. 19, for the display panel 3 (display panel 3b) on a right side, three points (fixing point P2, fixing point P4, and fixing point P5) existing outside the display panel 3 are considered as fixing points. Among them, a midpoint between the fixing point P2 and the fixing point P5 is defined as the intermediate point PQ. A point on the corner 2D at an equal distance from the fixing points P2 and P5 is set as the equidistance point H0.

In the case where the fixing point P exists outside the display panel 3, the intermediate point PQ may also be positioned outside the display panel 3 depending on a positional relation. At this time, a distance Z (a length of an intersection line between a main surface of the display panel 3 and the virtual plane R from an upper end to the point corresponding to the intermediate point PQ) has a negative value, and the ratio $Z/Z_{cg}$ is 0.5 or less, and thus it can be determined as an in-dash type.

The shapes of the cover member 2 and the display panel 3 are not limited to a rectangular shape (see FIG. 1 and the like), and may be a square shape other than a rectangular shape, or other polygons as illustrated in FIG. 19, or may also have other shapes such as a circular shape. The cover member 2 and the display panel 3 are not limited to flat plate-shaped members, and may be curved plate-shaped members. In the case where the cover member 2 is curved, the curvature radius thereof is preferably 50 mm to 10,000 mm, more preferably 100 mm to 5,000 mm, and still more preferably 200 mm to 3,000 mm. The curvature radius is preferably 50 mm or more, more preferably 100 mm or more, and still more preferably 200 mm or more. The curvature radius is, for example, 10,000 mm or less, preferably 5,000 mm or less, and more preferably 3,000 mm or less.

(5. Effects)

As described above, the display device 1 according to the present embodiment is an in-vehicle display device in which a cover member 2, a display panel 3, and a bottom member 5 fixed to a vehicle are disposed to overlap along a Z direction (first direction). The cover member 2 has a first main surface 2A opposite in the Z direction, a second main surface 2B in the Z direction, and an end surface 2C connected to the first main surface 2A and the second main surface 2B. The bottom member 5 has a plate portion 6 and ribs 7 protruding from a main surface 6B of the plate portion 6 in the Z direction, and at least two fixing points P to be fixed to a vehicle are formed on a surface of the bottom member 5 in the Z direction. When a virtual plane passing through an intermediate point PQ of the two fixing points P and perpendicular to a line connecting the two fixing points P is defined as a virtual plane R, a length of an intersection line between the first main surface 2A of the cover member 2 and the virtual plane R is defined as a distance $YH_{cg}$, and a length of the intersection line between the main surface of the display panel 3 and the virtual plane R from an upper end to a point corresponding to the intermediate point PQ is defined as a distance YH, the ratio $YH/YH_{cg}$ of the distance YH to the distance $YH_{cg}$ is 0.5 or less. A position on a corner 2D formed by the first main surface 2A and the end surface 2C of the cover member 2 where distances from the two fixing points P are equal is defined as an equidistance point H0, a position on the corner 2D within a predetermined distance range from the equidistance point H0 is defined as a reference point H, a virtual line that passes through the reference point H and the bottom member 5 and is inclined at an angle of 30° or more and 45° or less with respect to the Z direction is defined as a virtual line D, and n is an integer of 2 or more. In this case, members up to an n-th layer are disposed on the virtual line D with the cover member 2 as a first layer, except for the bottom member 5.

The display device 1 satisfies Formula (1). In Formula (1), t is a thickness (mm) of the cover member 2 in the Z direction, and Q is a value obtained by Formula (2).

In Formula (2), $E_D$ is the Young's modulus (GPa) of the bottom member 5, $E_{cg}$ is the Young's modulus (GPa) of the cover member 2, $E_n$ is the Young's modulus (GPa) of the member of the n-th layer, $t_n$ is a thickness (mm) of the member of the n-th layer in the Z direction at a region passing through the virtual line D, and to is a value obtained by Formula (3).

In Formula (3), a is a thickness (mm) of the plate portion 6 of the bottom member 5 in the Z direction, $w_2$ is a width (mm) of a first rib Rb 1 closest to the point p on the plate portion 6 through which the virtual line D passes among the ribs 7 of the bottom member 5, $w_1$ is a distance (mm) between the first rib Rb 1 and the second rib Rb2 that is positioned in an extending direction of a line perpendicular to a center line of the first rib Rb1 and passing through the point p on the plate portion 6 through which the virtual line D passes, h is a thickness (mm) of the rib 7 in the Z direction, and b is represented by Formula (4).

The display device 1 according to the present embodiment is an in-dash type in-vehicle display device having the ratio $YH/YH_{cg}$ of 0.5 or more. In such an in-dash type display device, it is required to improve the end portion impact and reduce damage to the cover member 2. On the other hand, since the display device 1 according to the present embodiment is designed to satisfy Formula (1), it is possible to improve the end portion impact and reduce the damage to the cover member 2.

The display device 1 according to the present embodiment is an in-vehicle display device in which a cover member 2, a display panel 3, and a bottom member 5 fixed to a vehicle are disposed to overlap along a Z direction (first direction). The cover member 2 has a first main surface 2A opposite in the Z direction, a second main surface 2B in the Z direction, and an end surface 2C connected to the first main surface 2A and the second main surface 2B. The bottom member 5 has a plate portion 6 and ribs 7 protruding from a main surface 6B of the plate portion 6 in the Z direction, and one fixing point P to be fixed to a vehicle is formed on a surface of the bottom member 5 in the Z direction. When a virtual plane passing through the fixing point P and including a thickness direction (Z direction) of the cover member 2 at the fixing point P and a vertical direction (Y direction) is defined as a virtual plane R, a length of an intersection line between the first main surface 2A of the cover member 2 and the virtual plane R is defined as a distance $YH_{cg}$, and a length of the intersection line between the main surface of the display panel 3 and the virtual plane R from an upper end to a point corresponding to the intermediate point PQ is defined as a distance YH, the ratio $YH/YH_{cg}$ of the distance YH to the distance $YH_{cg}$ is 0.5 or less. A position on a corner 2D formed by the first main surface 2A and the end surface 2C of the cover member 2 where a distance from the fixing point P is the shortest is defined as an equidistance point H0, a position on the corner 2D within a predetermined distance range from the equidistance point H0 is defined as a reference point H, a virtual line that passes through the reference point H and the bottom member 5 and is inclined at an angle of 30° or more and 45° or less with respect to the Z direction is defined as a virtual line D, and n is an integer of 2 or more. In this case, members up to an n-th layer are disposed on the virtual line D with the cover member 2 as a first layer, except for the bottom member 5.

The display device 1 satisfies Formula (1).

Since the display device 1 according to the present embodiment is designed to satisfy Formula (1), it is possible to improve the end portion impact and reduce the damage to the cover member 2.

At least one of the members (intermediate members) between the cover member 2 and the bottom member 5 on the virtual line D preferably has a base portion and ribs protruding from a surface of the base portion in a direction opposite to the Z direction. When in a member which is the most opposite to the Z direction among the intermediate members having the base portion and the ribs, a distance between the ribs closest to the reference point H is defined as L, Q' based on Formula (5) is preferably a value that satisfies Formula (1)'.

In the case where there is a rib on a surface of the intermediate member opposite in the Z direction, since the cover member 2 is supported by the rib, it is assumed that the cover member 2 is more likely to be damaged. On the other hand, in the case where Q is designed as the value of Formula (5) and to satisfy Formula (1), and the influence in the case of being supported by the rib is taken into account, even in the case where the intermediate member has ribs, damage to the cover member 2 can be suitably reduced.

The bottom member 5 is preferably configured to be fixed to a vehicle by using a bracket 9. By being fixed to a vehicle via the bracket 9, the display device 1 can be appropriately fixed to the vehicle.

Q obtained by Formula (2) is preferably 1.5 or more. Q' obtained by Formula (5) is preferably 1.5 or more. It is also preferable that both Q and Q' are 1.5 or more. In the case where Q and Q' falls within this range, the rigidity of the bottom member 5 can be ensured, and the damage to the housing of the display device 1 can be suitably reduced.

The cover member 2 is preferably made of a strengthened glass having a compressive stress layer having a thickness of 10 μm or more. It is preferable that the thickness t of the cover member 2 is 0.5 mm or more and 2.5 mm or less, the Young's modulus $E_{cg}$ of the cover member 2 is 60 GPa or more and 90 GPa or less, the Young's modulus of the display panel 3 is 2 GPa or more and 90 GPa or less, and the Young's modulus of the bottom member 5 is 40 GPa or more and 250 GPa or less. In the case where the Young's modulus or the like of each member falls within these respective ranges, it is possible to reduce damage to the cover member 2.

In the display device 1, in a head impact test in which an impactor is caused to collide with the reference point H of the cover member 2 through which the virtual line D passes so that the energy at the time of collision is 152 J, a deceleration of the impactor is preferably 50 G or more. In the case where the deceleration falls within this range, the cover member 2 is likely to be damaged. However, the damage to the cover member 2 can be appropriately reduced by designing to satisfy Formula (1). The deceleration is not particularly limited, and is, for example, 150 G or less.

As the conditions of the head impact test, the conditions in the simulation in which an impactor is caused to collide in the subsequent Examples are used.

Examples

(Examples)

Next, Examples will be described. The embodiments may be modified as long as the effects of the invention are exhibited.

In Examples, a head impact test was simulated by generating a simulation model of the display device 1 and executing a simulation of applying an impact to the reference point H with respect to the simulation model of the display device 1. Hereinafter, the model of each Example will be described. Table 1 is a table for describing each Example.

[Table 1]

(Table 1)

| | Conditions | | | | | | | | |
|---|---|---|---|---|---|---|---|---|---|
| | Cover member thickness (mm) | Bottom member thickness (mm) | Sidewall member thickness (mm) | L/2 (mm) | Cover member rigidity | Bottom member rigidity | Sidewall member rigidity | Q | Satisfy Formula (1) |
| Ex. 1 | 0.7 | 2 | 1.5 | 13 | 36.26 | 280 | 157.5 | 31.7 | Yes |
| Ex. 2 | 0.7 | 2 | 1.5 | 15 | 36.26 | 280 | 157.5 | 48.8 | No |
| Ex. 3 | 0.7 | 2 | 2.5 | 16 | 36.26 | 280 | 437.5 | 24.2 | Yes |
| Ex. 4 | 0.7 | 2.5 | 1 | 12 | 36.26 | 437.5 | 70 | 71.1 | No |
| Ex. 5 | 0.7 | 2.5 | 2.5 | 12 | 36.26 | 437.5 | 437.5 | 16.0 | Yes |
| Ex. 6 | 0.7 | 3 | 1.5 | 15 | 36.26 | 630 | 157.5 | 109.7 | No |
| Ex. 7 | 1.3 | 2 | 1.5 | 13 | 125.06 | 280 | 157.5 | 19.0 | Yes |
| Ex. 8 | 1.3 | 2 | 1.5 | 15 | 125.06 | 280 | 157.5 | 63.4 | Yes |
| Ex. 9 | 1.3 | 2 | 2.5 | 16 | 125.06 | 280 | 437.5 | 88.6 | No |
| Ex. 10 | 1.3 | 2.5 | 1 | 12 | 125.06 | 437.5 | 70 | 75.2 | No |
| Ex. 11 | 1.3 | 2.5 | 2.5 | 12 | 125.06 | 437.5 | 437.5 | 42.7 | Yes |
| Ex. 12 | 1.3 | 3 | 1.5 | 15 | 125.06 | 630 | 157.5 | 91.9 | No |
| Ex. 13 | 1.1 | 2 | 1.5 | 13 | 89.54 | 280 | 157.5 | 13.1 | Yes |
| Ex. 14 | 1.1 | 2 | 1.5 | 15 | 89.54 | 280 | 157.5 | 44.1 | Yes |
| Ex. 15 | 1.1 | 2 | 2.5 | 16 | 89.54 | 280 | 437.5 | 56.0 | No |
| Ex. 16 | 1.1 | 2.5 | 1 | 12 | 89.54 | 437.5 | 70 | 71.9 | No |
| Ex. 17 | 1.1 | 2.5 | 2.5 | 12 | 89.54 | 437.5 | 437.5 | 86.8 | No |
| Ex. 18 | 1.1 | 3 | 1.5 | 15 | 89.54 | 630 | 157.5 | 20.7 | Yes |

(Table 1, continued)

|  | Evaluation results | |
|---|---|---|
|  | G value | Determination |
| Ex. 1 | 62 | Good |
| Ex. 2 | 61 | Defective |
| Ex. 3 | 70 | Good |
| Ex. 4 | 65 | Defective |
| Ex. 5 | 64 | Good |
| Ex. 6 | 67 | Defective |
| Ex. 7 | 69 | Good |
| Ex. 8 | 79 | Good |
| Ex. 9 | 77 | Defective |
| Ex. 10 | 77 | Defective |
| Ex. 11 | 77 | Good |
| Ex. 12 | 81 | Defective |
| Ex. 13 | 67 | Good |
| Ex. 14 | 72 | Good |
| Ex. 15 | 77 | Defective |
| Ex. 16 | 67 | Defective |
| Ex. 17 | 71 | Defective |
| Ex. 18 | 74 | Good |

(Example 1)

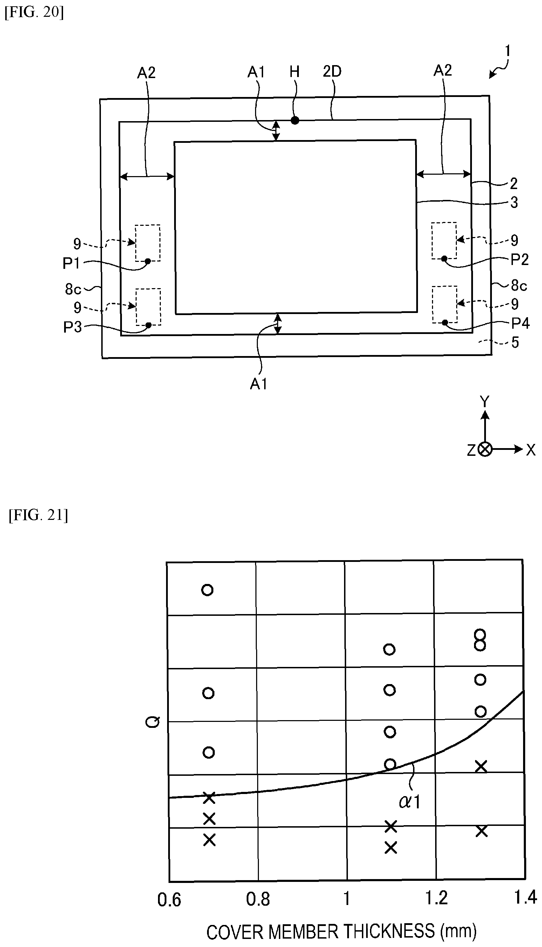

FIG. 20 is a schematic front view of a display device according to Examples. In Example 1, a simulation model of a display device 1 as illustrated in FIG. 20 was prepared. As illustrated in FIG. 20, the model of the display device 1 includes the cover member 2, the display panel 3, the sidewall member 8c having ribs opposite in the Z direction, and the bottom member 5. That is, the model of the display device 1 employs the structure described in FIGS. 11 and 12.

In the model of the display device 1 of Example 1, the size of the cover member 2 was set to 250 mm in the X direction and 150 mm in the Y direction, the thickness t in the Z direction was set to 0.7 mm, and the Young's modulus $E_{cg}$ was set to 74 GPa. The rigidity of the cover member 2 was calculated as $E_{cg} \cdot t^2$ and was set to the value shown in Table 1.

In the model of the display device 1, the size of the display panel 3 was set to 170 mm in the X direction and 125 mm in the Y direction, and the thickness in the Z direction was set to 1.1 mm.

The distance A1 between the end portion of the cover member 2 in the Y direction and the end portion of the display panel 3 in the Y direction was set to 12 mm, and the distance A2 between the end portion of the cover member 2 in the X direction and the end portion of the display panel 3 in the X direction was set to 40 mm.

In the model of the display device 1, the size of the bottom member 5 was set to be the same as that of the cover member 2 in the X direction and the Y direction, the thickness of the plate portion 6 was set to 2 mm, and the shape of the rib 7 was set such that the value $t_D$ corresponding to the thickness when taking the rib 7 into consideration was 2 mm. The Young's modulus $E_D$ of the bottom member 5 was set to 70 GPa. The rigidity of the bottom member 5 was calculated as $E_D \cdot t_D^2$ and was set to the value shown in Table 1.

The thickness of the base portion 8c1 of the sidewall member 8c in the Z direction was set to 1.5 mm, and a half value (L/2) of the distance L between the ribs 8c2 closest to the reference point H was set to 13 mm. The Young's modulus of the sidewall member 8c was set to 2.2 GPa. The rigidity of the sidewall member 8c was calculated in the same manner as in the cover member 2, and was set to the value shown in Table 1.

In the model of the display device 1, the brackets 9 were disposed on a surface of the bottom member 5 in the Z direction with the fixing points P set such that the ratio $YH/YH_{cg}$ was 0.5. The position of each fixing point in the X direction was a center position between an end portion of the cover member 2 in the X direction (or a direction opposite to the X direction) and an end portion of the display panel 3 in the X direction (or a direction opposite to the X direction).

The reference point H was set at a position on the corner 2D of the cover member 2 in the Y direction where the distances from the fixing points P1 and P2 were equal.

The virtual line D was set to pass through the reference point H and be inclined at an angle of 30° with respect to the Z direction.

In Example 1, as for the members other than the bottom member 5 passing through the virtual line D, the first layer was the cover member 2, the second layer was the sidewall member 8c, and n = 2.

Q in the model of Example 1 was a value shown in Table 1 and satisfies Formula (1).

(Examples 2 to 18)

In Examples 2 to 18, models were generated by changing the parameters shown in Table 1 with respect to Example 1.

(Evaluation)

A simulation was executed in which an impactor was caused to collide with the reference point H of the model generated in each Example under the following conditions.

- Collision energy of impactor: 152 (J)
- Impactor weight: 6.8 (kg)
- Impactor diameter: 165 (mm)
- Impactor collision angle (inclination angle of collision direction of impactor with respect to Z direction): 30°

(Evaluation Results)

Analysis results of the stress generated in the cover member 2 when the impactor collides with the reference point P were acquired by the simulation. In the case where the maximum stress generated in the cover member 2 was less than a predetermined threshold, the determination was "good" (pass), and in the case where the maximum stress was equal to or greater than the threshold, the determination was "defective" (fail). As shown in Table 1, in the simulation, the analysis results of the deceleration of the impactor were also acquired.

FIG. 21 is a graph showing the value of Q and the evaluation result in each Example. The horizontal axis in FIG. 21 represents the thickness of the cover member 2, and the vertical axis represents the Q value, and each plot in FIG. 21 shows the result of each Example. The line $\alpha1$ is a boundary line that satisfies Formula (1) (a line that connects plots of the Q value and the thickness of the cover member 2 in the case where the left side and the right side of Formula (1) have the same value). That is, the plots above a line L1 satisfy Formula (1), and the plots below the line L1 do not satisfy Formula (1).

The plots of Examples 1, 3, 5, 7, 8, 11, 13, 14, and 18, which are Inventive Examples, are represented by a circle in FIG. 21, and it can be seen that Q satisfies Formula (1). In these Examples, the determination is represented by circle, that is, the determination is "good", and it can be seen that the damage to the cover member 2 can be reduced.

On the other hand, the plots of Comparative Examples 2, 4, 6, 9, 10, 12, and 15 to 17 are represented by crosses in FIG. 21, and it can be seen that Q does not satisfy Formula (1). In these Comparative Examples, the determination is represented by a cross, that is, the determination is "defective", and it can be seen that the damage to the cover member 2 cannot be reduced.

Although the embodiment of the present invention has been described above, the embodiment is not limited to the content of this embodiment. In addition, the components described above should include those that can be easily conceived by a person skilled in the art, those that are substantially the same, and those within a so-called equivalent range. Further, the above components can be appropriately combined. Further, various omissions, substitutions, or modifications of the components can be made without departing from the gist of the embodiment described above.

The present application is based on Japanese Patent Application (No. 2021-180542) filed on November 4, 2021, and the contents thereof are incorporated herein by reference.

REFERENCE SIGNS LIST

    1 display device

2 cover member
2A first main surface
2B second main surface
2C end surface
2D corner
3 display panel
4 backlight unit
5 bottom member
6 plate portion
7 rib
8 sidewall member
9 bracket
10 interior portion
D virtual line
H reference point
H0 equidistance point
P fixing point

**Claims**

1. An in-vehicle display device, comprising:

a cover member;
a display panel; and
a bottom member configured to be fixed to a vehicle, the cover member, the display panel, and the bottom member being stacked in this order, wherein
in a thickness direction of the cover member, when a direction from the cover member toward the bottom member is defined as a first direction,
the cover member includes a first main surface opposite to the first direction, a second main surface in the first direction, an end surface connecting the first main surface and the second main surface, and a corner formed by the first main surface and the end surface,
the bottom member includes a plate portion and ribs protruding from a main surface of the plate portion in the first direction, and at least two fixing points configured to be fixed to the vehicle are formed on a main surface of the bottom member in the first direction,
when a virtual plane passing through an intermediate point between two of the fixing points and perpendicular to a line connecting the two fixing points is defined as a virtual plane R, a length of an intersection line between a main surface of the cover member and the virtual plane R is defined as a distance $YH_{cg}$, and a length of an intersection line between a main surface of the display panel and the virtual plane R from an upper end to a point corresponding to the intermediate point is defined as a distance YH, a ratio $YH/YH_{cg}$ of the distance YH to the distance $YH_{cg}$ is 0.5 or less,
when a position on the corner of the cover member where distances from the two fixing points are equal is defined as an equidistance point, a position on the corner within a predetermined distance range from the equidistance point is defined as a reference point, a virtual line that passes through the reference point and the bottom member and is inclined at an angle of 30° or more and 45° or less with respect to the first direction is defined as a virtual line D, and n is an integer of 2 or more, members up to an n-th layer are disposed on the virtual line D with the cover member as a first layer, except for the bottom member, and
the following Formula (1) is satisfied:
[Math. 1]

$$Q \leqq 109.17t^2 - 165.5t + 94.058 \qquad \text{... Formula (1)}$$

in Formula (1),

t is a thickness (mm) of the cover member in the first direction, and
Q is a value obtained by the following Formula (2);
[Math. 2]

$$Q = E_D \cdot t_D{}^2 / (Ecg \cdot t^2 + \cdots + E_n \cdot t_n{}^2)/100 \qquad \text{... Formula (2)}$$

in Formula (2),

$E_D$ is a Young's modulus (GPa) of the bottom member,
$E_{cg}$ is a Young's modulus (GPa) of the cover member,
$E_n$ is a Young's modulus (GPa) of the member of the n-th layer,
$t_n$ is a thickness (mm) of the member of the n-th layer in the first direction at a region passing through the virtual line D, and
to is a value obtained by the following Formula (3);
[Math. 3]

$$t_D = \sqrt[3]{a^3 + \frac{w_2}{w_1}h^3 + 12a\left(b - \frac{a}{2}\right)^2 12\frac{w_2}{w_1}h\left(\frac{h}{2} + a - b\right)^2} \qquad \text{... Formula (3)}$$

in Formula (3),

a is a thickness (mm) of the plate portion of the bottom member in the first direction,
$w_2$ is a width (mm) of a first rib closest to a point on the plate portion through which the virtual line D passes among the ribs of the bottom member,
$w_1$ is a distance (mm) between the first rib and a second rib that is positioned in an extending direction of a line perpendicular to a center line of the first rib and passing through the point on the plate portion through which the virtual line D passes,
h is a thickness (mm) of the rib in the first direction, and
b is represented by the following Formula (4); and
[Math. 4]

$$b = \frac{0.5w_1 \cdot a^2 + 0.5w_2 \cdot h^2 + w_2 \cdot a \cdot h}{w_1 \cdot a + w_2 \cdot h} \qquad \text{... Formula (4)}$$

in Formula (4),

a is the thickness (mm) of the plate portion of the bottom member in the first direction,
$w_2$ is the width (mm) of the first rib closest to the point on the plate portion through which the virtual line D' passes among the ribs of the bottom member,
$w_1$ is the distance (mm) between the first rib and the second rib that is positioned in the extending direction of the line perpendicular to the center line of the first rib and passing through the point on the plate portion through which the virtual line D passes, and
h is the thickness (mm) of the first rib and the second rib in the first direction.

2. An in-vehicle display device, comprising:

a cover member;
a display panel; and
a bottom member configured to be fixed to a vehicle, the cover member, the display panel, and the bottom member being stacked in this order, wherein
in a thickness direction of the cover member, when a direction from the cover member toward the bottom member is defined as a first direction,
the cover member includes a first main surface opposite to the first direction, a second main surface in the first direction, an end surface connecting the first main surface and the second main surface, and a corner formed by the first main surface and the end surface,
the bottom member includes a plate portion and ribs protruding from a main surface of the plate portion in the first direction, and one fixing point configured to be fixed to the vehicle is formed on a main surface of the bottom member in the first direction,

when a virtual plane passing through the fixing point and including the thickness direction and a vertical direction of the cover member at the fixing point is defined as a virtual plane R, a length of an intersection line between a main surface of the cover member and the virtual plane R is defined as a distance $YH'_{cg}$, and a length of an intersection line between a main surface of the display panel and the virtual plane R from an upper end to a point corresponding to the fixing point is defined as a distance YH, a ratio $YH/YH_{cg}$ of the distance YH to the distance $YH_{cg}$ is 0.5 or less,

when a position on the corner of the cover member where a distance from the fixing point is the shortest is defined as an equidistance point, a position on the corner within a predetermined distance range from the equidistance point is defined as a reference point, a virtual line that passes through the reference point and the bottom member and is inclined at an angle of 30° or more and 45° or less with respect to the first direction is defined as a virtual line D, and n is an integer of 2 or more, members up to an n-th layer are disposed on the virtual line D when the cover member is a first layer and the bottom member is excluded, and

the following Formula (1) is satisfied:

[Math. 5]

$$Q \leqq 109.17t^2 - 165.5t + 94.058 \qquad \text{... Formula (1)}$$

in Formula (1),

t is a thickness (mm) of the cover member in the first direction, and
Q is a value obtained by the following Formula (2);

[Math. 6]

$$Q = E_D \cdot t_D{}^2 / (Ecg \cdot t^2 + \cdots + E_n \cdot t_n{}^2) / 100 \qquad \text{... Formula (2)}$$

in Formula (2),

$E_D$ is a Young's modulus (GPa) of the bottom member,
$E_{cg}$ is a Young's modulus (GPa) of the cover member,
$E_n$ is a Young's modulus (GPa) of the member of the n-th layer,
$t_n$ is a thickness (mm) of the member of the n-th layer in the first direction at a region passing through the virtual line D', and
$t_D$ is a value obtained by the following Formula (3);

[Math. 7]

$$t_D = \sqrt[3]{a^3 + \frac{w_2}{w_1}h^3 + 12a\left(b - \frac{a}{2}\right)^2 12\frac{w_2}{w_1}h\left(\frac{h}{2} + a - b\right)^2} \qquad \text{... Formula (3)}$$

in Formula (3),

a is a thickness (mm) of the plate portion of the bottom member in the first direction,
$w_2$ is a width (mm) of a first rib closest to a point on the plate portion through which the virtual line D' passes among the ribs of the bottom member,
$w_1$ is a distance (mm) between the first rib and a second rib that is positioned in an extending direction of a line perpendicular to a center line of the first rib and passing through the point on the plate portion through which the virtual line D passes,
h is a thickness (mm) of the first rib and the second rib in the first direction, and
b is represented by the following Formula (4); and

[Math. 8]

$$b = \frac{0.5w_1 \cdot a^2 + 0.5w_2 \cdot h^2 + w_2 \cdot a \cdot h}{w_1 \cdot a + w_2 \cdot h} \qquad \text{... Formula (4)}$$

in Formula (4),

a is the thickness (mm) of the plate portion of the bottom member in the first direction,
$w_2$ is the width (mm) of the first rib closest to the point on the plate portion through which the virtual line D' passes among the ribs of the bottom member,
$w_1$ is the distance (mm) between the first rib and the second rib that is positioned in the extending direction of the line perpendicular to the center line of the first rib and passing through the point on the plate portion through which the virtual line D passes, and
h is the thickness (mm) of the first rib and the second rib in the first direction.

3. The display device according to claim 1 or 2, wherein

at least one of the members between the cover member and the bottom member on the virtual line D has a base portion and ribs protruding from a surface of the base portion in a direction opposite to the first direction, and when in a member in the most opposite to the first direction among the members having the base portion and the ribs protruding from the base portion, a distance between ribs closest to the reference point is defined as L, a value of Q' obtained by the following Formula (5) further satisfies the following Formula (1).

[Math. 9]

$$Q' \leqq 109.17t^2 - 165.5t + 94.058 \qquad \text{... Formula (1)'}$$
$$Q' = E_D \cdot t_D{}^2 / (Ecg \cdot t^2 + \cdots + E_n \cdot t_n{}^2) \times (L/2)^3 / 100 \qquad \text{... Formula (5)}$$

4. The display device according to claim 3, wherein Q' obtained by Formula (5) is 1.5 or more.

5. The display device according to any one of claims 1 to 4, wherein the bottom member is configured to be fixed to the vehicle by using a bracket.

6. The display device according to any one of claims 1 to 5, wherein Q obtained by Formula (2) is 1.5 or more.

7. The display device according to any one of claims 1 to 6, wherein

the cover member is made of a strengthened glass having a compressive stress layer having a thickness of 10 $\mu$m or more,
the cover member has the thickness of 0.5 mm or more and 2.5 mm or less,
the cover member has the Young's modulus of 60 GPa or more and 90 GPa or less,
the display panel has a Young's modulus of 2 GPa or more and 90 GPa or less, and
the bottom member has the Young's modulus of 40 GPa or more and 250 GPa or less.

8. The display device according to any one of claims 1 to 7, wherein
in a head impact test in which an impactor is caused to collide with the reference point of the cover member through which the virtual line D passes so that an energy at the time of collision is 152 J, a deceleration of the impactor is 50 G or more.

[FIG. 1]

[FIG. 2]

[FIG. 3]

[FIG. 4]

[FIG. 5]

[FIG. 6]

[FIG. 7A]

[FIG. 7B]

[FIG. 8]

[FIG. 9]

[FIG. 10]

[FIG. 11]

[FIG. 12]

[FIG. 13]

[FIG. 14]

[FIG. 15]

[FIG. 16]

[FIG. 17]

[FIG. 18]

[FIG. 19]

35

[FIG. 20]

[FIG. 21]

COVER MEMBER THICKNESS (mm)

## INTERNATIONAL SEARCH REPORT

| International application No. |
| --- |
| **PCT/JP2022/040846** |

**A.    CLASSIFICATION OF SUBJECT MATTER**

*G09F 9/00*(2006.01)i; *B60K 35/00*(2006.01)i

FI:    G09F9/00 350Z; B60K35/00 Z; G09F9/00 351

According to International Patent Classification (IPC) or to both national classification and IPC

**B.    FIELDS SEARCHED**

Minimum documentation searched (classification system followed by classification symbols)

B60K35/00-37/06; B60R9/00-11/06; G09F9/00-9/46

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| A | JP 2020-027169 A (AGC INC.) 20 February 2020 (2020-02-20)<br>entire text, all drawings | 1-8 |
| A | WO 2016/027812 A1 (ASAHI GLASS CO., LTD.) 25 February 2016 (2016-02-25)<br>entire text, all drawings | 1-8 |
| A | JP 2014-234009 A (DENSO CORP.) 15 December 2014 (2014-12-15)<br>entire text, all drawings | 1-8 |
| A | JP 2018-169616 A (AGC INC.) 01 November 2018 (2018-11-01)<br>entire text, all drawings | 1-8 |
| A | JP 9-113880 A (ALPINE ELECTRON., INC.) 02 May 1997 (1997-05-02)<br>entire text, all drawings | 1-8 |
| A | JP 2018-131149 A (ALPINE ELECTRON., INC.) 23 August 2018 (2018-08-23)<br>entire text, all drawings | 1-8 |
| A | JP 2020-102113 A (STANLEY ELECTRIC CO., LTD.) 02 July 2020 (2020-07-02)<br>entire text, all drawings | 1-8 |

☑ Further documents are listed in the continuation of Box C.       ☑ See patent family annex.

| | |
| --- | --- |
| \*    Special categories of cited documents:<br>"A"    document defining the general state of the art which is not considered to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
| --- | --- |
| **20 December 2022** | **10 January 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2022/040846**

**C.    DOCUMENTS CONSIDERED TO BE RELEVANT**

| Category* | Citation of document, with indication, where appropriate, of the relevant passages | Relevant to claim No. |
|---|---|---|
| A | JP 2015-098195 A (YAMAHA MOTOR CO., LTD.) 28 May 2015 (2015-05-28) entire text, all drawings | 1-8 |
| P, A | WO 2022/215687 A1 (AGC INC.) 13 October 2022 (2022-10-13) entire text, all drawings | 1-8 |

Form PCT/ISA/210 (second sheet) (January 2015)

**INTERNATIONAL SEARCH REPORT**
Information on patent family members

| International application No. |
| --- |
| **PCT/JP2022/040846** |

| Patent document cited in search report | | | Publication date (day/month/year) | Patent family member(s) | | | Publication date (day/month/year) |
| --- | --- | --- | --- | --- | --- | --- | --- |
| JP | 2020-027169 | A | 20 February 2020 | US 2020-0050049 A1 entire text, all drawings CN 110824747 A | | | |
| WO | 2016/027812 | A1 | 25 February 2016 | CN 106604902 A entire text, all drawings KR 10-2017-0048249 A | | | |
| JP | 2014-234009 | A | 15 December 2014 | (Family: none) | | | |
| JP | 2018-169616 | A | 01 November 2018 | US 2018-0065881 A1 entire text, all drawings CN 107615367 A | | | |
| JP | 9-113880 | A | 02 May 1997 | (Family: none) | | | |
| JP | 2018-131149 | A | 23 August 2018 | (Family: none) | | | |
| JP | 2020-102113 | A | 02 July 2020 | US 2020-0201467 A1 entire text, all drawings | | | |
| JP | 2015-098195 | A | 28 May 2015 | EP 002878479 A2 entire text, all drawings | | | |
| WO | 2022/215687 | A1 | 13 October 2022 | (Family: none) | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016027812 A
- JP 2021180542 A